# EUROPÄISCHE PATENTSCHRIFT

(11) **EP 2 891 162 B1**
(45) Veröffentlichungstag und Bekanntmachung des Hinweises auf die Patenterteilung: **09.10.2019**
(21) Anmeldenummer: 13753653.8
(22) Anmeldetag: 30.08.2013
(51) Int. Cl.: H01F 17/00, H01F 17/04, H01F 3/00, H01F 5/00, G01R 33/00, G01B 7/00, G01S 5/02, G01S 13/76, H01Q 7/08, H01Q 21/24

(54) **SPULENANORDNUNG ZUM ERZEUGEN EINES ROTIERENDEN ELEKTROMAGNETISCHEN FELDS UND ORTUNGSSYSTEM ZUM BESTIMMEN EINER POSITION EINES IDENTIFIKATIONSGEBERS**
COIL ARRANGEMENT FOR GENERATION OF A ROTATING ELECTROMAGNETIC FIELD AND POSITIONING SYSTEM FOR DETERMINING THE POSITION OF AN IDENTIFICATION DEVICE
AGENCEMENT DE BOBINE POUR LA GÉNÉRATION D'UN CHAMP TOURNANT ÉLECTROMAGNÉTIQUE ET SYSTÈME DE DÉTERMINATION DE POSITION D'UN DISPOSITIF D'IDENTIFICATION

(30) Priorität: 01.09.2012 DE 102012017390
(43) Veröffentlichungstag der Anmeldung: 08.07.2015
(73) Patentinhaber: Volkswagen Aktiengesellschaft, 38440 Wolfsburg (DE)
(72) Erfinder: ETTE, Bernd, 38442 Wolfsburg (DE); HOLLDACK, Bernhard, 38448 Wolfsburg (DE)
(86) Internationale Anmeldenummer: PCT/EP2013/067968
(87) Internationale Veröffentlichungsnummer: WO 2014/033246

(56) Entgegenhaltungen:
- EP-A1- 0 576 187
- DE-A1-102007 042 370
- DE-B3- 10 325 246
- JP-A- 2008 060 634
- US-A1- 2003 168 921

## Beschreibung

Verschiedene Ausführungsformen betreffen eine Spulenanordnung zur Erzeugen eines rotierenden elektromagnetischen Felds, sowie Ortungssysteme zum Bestimmen einer Position eines Identifikationsgebers. Solche Ortungssysteme können erfindungsgemäße Spulenanordnungen umfassen.

Es sind Techniken bekannt, welche eine Ortung, d.h. eine Positionsbestimmung, z.B. von Identifikationsgebern erlauben. Ein Beispiel für Identifikationsgeber wäre zum Beispiel ein Schlüssel für ein Kraftfahrzeug: so sind Techniken bekannt, welche es erlauben, die Position des Schlüssels im Umfeld des Kraftfahrzeugs zu bestimmen, um eine Zugangskontrolle zu dem Kraftfahrzeug zu erreichen. Herkömmliche Techniken beruhen hierbei typischerweise auf einer Messung einer Feldstärke eines von einem zentralen Sender ausgesendeten elektromagnetischen Feldes. Da die Feldstärke für zunehmende Entfernungen zu dem Sender abnimmt (Dämpfung bzw. Abklingen der Feldstärke), kann aus einer Messung der Feldstärke durch eine Empfängerantenne im Schlüssel auf eine Position gegenüber dem Sender rückgeschlossen werden. Eine andere Möglichkeit besteht in einer Spulenanordnung mit drei Spulen, die zum Erzeugen eines rotierenden elektromagnetischen Felds geeignet ist. Eine solche Spulenanordnung, umfassend die Merkmale des Oberbegriffs von Anspruch 1, ist beispielsweise in EP 0 576 187 A1, US 2003/168921 A1 und in JP 2008 060634 A beschrieben.

Jedoch können solche Techniken eine begrenzte Genauigkeit der Bestimmung der Position des Identifikationsgebers aufweisen, z.B. aufgrund begrenzter Genauigkeit beim Messen der Feldstärke. Typische Genauigkeiten der Positionsbestimmung betragen bei bekannten Systemen z.B. 20 cm - ca. 2 m. Darüber hinaus können systematische Verfälschungen auftreten: insbesondere kann die Abnahme der Feldstärke des elektromagnetischen Felds aufgrund von zum Beispiel magnetischen Objekten, wie etwa die Fahrzeugkarosserie etc., gestört werden, so dass die Bestimmung der Position des Identifikationsgebers mit einem gewissen systematischen Fehler behaftet sein kann. Solche Fälle können es notwendig machen, eine einmalige manuelle Vermessung des Abklingens der Feldstärke in und um das Kraftfahrzeug herum zur Kalibration der Positionsbestimmung durchzuführen. Eine solche manuelle Vermessung kann zeitaufwändig sein und es können entsprechende Kosten entstehen. Die Kalibration selbst kann auch Fehlerquellen eröffnen. Darüber hinaus kann es nicht oder nur eingeschränkt möglich sein, die Positionsbestimmung auch innerhalb des Kraftfahrzeugs durchzuführen. Dies kann der Fall sein, da im Innenraum des Kraftfahrzeugs das Abklingen der Feldstärke durch verschiedenste Bauteile stark gestört sein kann. Obenstehend wurden nachteilige Effekte des Stands der Technik in Bezug auf die Techniken der Positionsbestimmung selbst erläutert. Es können aber auch nachteilige Effekte in Bezug auf die Systemarchitektur entsprechender Vorrichtungen auftreten, wie nachfolgend dargelegt wird. So weisen vorbekannte Ortungssysteme zur Positionsbestimmung typischerweise ein zentrales Steuergerät auf, welches mittels Versorgungsleitungen mit den einzelnen Sendern, die das elektromagnetische Feld aussenden, verbunden ist. Das Vorhalten dieser Versorgungsleitungen zu der Vielzahl von Sendern, typischerweise drei bis fünf, kann jedoch Bauraum in dem Kraftfahrzeug beanspruchen und eine zeitaufwändige und teure Verkabelung mit z.B. zwei- oder vieradrigen Leitungen notwendig machen. Darüber hinaus weisen solche Systeme häufig nur einen geringen Grad an Modularität auf, da es nicht ohne Weiteres möglich ist, das System auch funktionsfähig mit einer geringeren oder größeren Anzahl an Sendern zu betreiben - es ist daher nicht oder nur eingeschränkt möglich, verschiedene Ausstattungsvarianten bereitzustellen. Darüber hinaus kann das entsprechende System vergleichsweise störanfällig sein, da ein Ausfall oder eine Störung des zentralen Steuergeräts häufig in einem Komplettausfall des Systems resultieren kann.

Aus den oben genannten Gründen besteht ein Bedarf für verbesserte Techniken zum Bestimmen einer Position eines Empfängers. Insbesondere besteht ein Bedarf für Ortungssysteme, welche eine besonders genaue Positionsbestimmung innerhalb und außerhalb des Kraftfahrzeugs ermöglichen und gleichzeitig eine geringe Störanfälligkeit mit einer einfachen und kostengünstigen Systemarchitektur aufweisen.

Diese Aufgabe wird vom Gegenstand von Anspruch 1 gelöst. Die abhängigen Ansprüche definieren Ausführungsformen.

Die Erfindung betrifft eine Spulenanordnung zum Erzeugen eines rotierenden elektromagnetischen Felds gemäß Anspruch 1.

Die mindestens eine Spulenwicklung kann selbst mehrere Windungen eines elektrisch leitfähigen Drahts oder einer Leiterbahnen umfassen. Die Spulen können eine oder mehrere Spulenwicklungen umfassen - in anderen Worten können bei mehreren Spulenwicklungen einer Spule diese getrennt elektrisch kontaktierbar bzw. abgreifbar sein. Die Spulenwicklung ist dadurch gekennzeichnet, dass jede der Spulenwicklungen als Windungen ausbildende planare Leiterbahn auf einer Leiterplatte ausgestaltet ist, die Leiterplatte Aussparungen für das ferromagnetische Spulenjoch aufweist und das ferromagnetische Spulenjoch oberhalb und unterhalb der Leiterplatte angeordnet ist.

Die magnetische Kopplung kann durch einen bestimmten magnetischen Fluss charakterisiert sein, der z.B. eine bestimmte Größe aufweist. Ein magnetischer Fluss kann z.B. durch die durchgängigen Verbindungen der Spulenjoche erzeugt werden. Insbesondere kann die Spulenanordnung eingerichtet sein, dass der magnetische Fluss in einem Zentrum der Spulenanordnung einen bestimmten Wert, z.B. ungefähr oder genau 0 annimmt. Z.B. kann das Spulenjoch durchgängig, also ohne oder nur mit wenigen und / oder mit sehr kleinen bzw. kurzen Unterbrechungen bzw. Luftspalten sein. Es kann aus einem ferromagnetischen Material hergestellt sein, etwa Eisen, Chrom, Nickel, Oxiden dieser Materialien wie Ferrit, Legierungen aus Eisen, Chrom, Nickel, usf.. Die magnetische Kopplung kann eine ferromagnetische Austauschwechselwirkung bezeichnen, die sich über den gesamten Bereich des Spulenjochs ausbildet.

Es ist möglich, dass die mindestens drei Spulen in einer Spulenebene angeordnet sind und dass benachbarte Spulen innerhalb der Spulenebene unter Winkeln von 120° angeordnet sind. Z.B. können benachbarte Spulen unter Winkeln von 120° ± 10°, vorzugsweise ± 5°, besonders vorzugsweise ± 0,5° angeordnet sein. Es kann dann möglich sein, mit einer vergleichsweise einfachen Ansteuerung der Spulen (z.B. mit um 120° phasenversetzten Wechselspannungen) das rotierende elektromagnetische (em) Feld zu erzeugen. Im Allgemeinen sind aber auch andere Winkel, die benachbarte Spulen innerhalb der Spulenebene miteinander einschließen, möglich. Wenn die Spulen innerhalb der Spulenebene angeordnet sind, kann dies bedeuten, dass die Spulen (bzw. deren Zentralachsen) keinen oder nur einen geringen Winkel, z.B. ± 10°, vorzugsweise ±5°, besonders vorzugsweise ±1°, mit Vektoren einschließen, die die Spulenebene aufspannen.

Es kann möglich sein, bei unterschiedlichen Winkeln benachbarter Spulen innerhalb der Spulenebene eine Phasenverschiebung der Wechselspannungen zur Ansteuerung der verschiedenen Spulen entsprechend an die unterschiedlichen Winkel anzupassen, so dass ein rotierendes elektromagnetisches Feld erzeugt wird, welches eine konstante Winkelgeschwindigkeit aufweist.

Es ist natürlich auch möglich, z.B. vier oder sechs oder mehr Spulen zu verwenden, welche in der Spulenebene unter vorgegebenen Winkeln zu benachbarten Spulen angeordnet sind. Rein illustrativ und nicht limitierend können vier (sechs) Spulen unter Winkeln von 90° (60°) angeordnet sein. Weitere entsprechende symmetrische Konfigurationen, bei welchen benachbarte Spulen immer gleiche Winkel zueinander aufweisen, sind möglich.

Obenstehend wurden Ausführungsformen beschrieben, bei denen alle Spulen innerhalb einer Spulenebene liegen. Eine solche Spulenebene kann eine Rotationsebene des rotierenden em Felds bestimmen. Es sind aber auch Ausführungsformen möglich, in denen einzelne oder mehrere Spulen außerhalb der Spulenebene, die durch mindestens zwei Spulen definiert wird, liegen. In anderen Worten können einzelne oder mehrere Spulen gegenüber der Spulenebene verkippt sein. Auch in einem solchen Fall kann es möglich sein, dass die Spulenebene die Rotationsebene definiert.

Es ist z.B. möglich, dass eine dritte Spule der mindestens drei Spulen einen Winkel mit einer von einer ersten und zweiten Spule der mindestens drei Spulen aufgespannten Spulenebene einschließt. Z.B. kann der Winkel, den die dritte Spule mit der Spulenebene einschließt, in einem Bereich von 1° - 45° liegen, vorzugsweise in einem Bereich von 20° - 30°. In einem solchen Fall, in dem einzelne Spulen gegenüber der Spulenebene verkippt sind, kann eine kleinere Abmessung der Spulenanordnung innerhalb der Spulenebene erreicht werden. Bei Anwendungen, in denen die Spulenanordnung in Bereichen z.B. eines Kraftfahrzeugs positioniert werden soll, bei denen ein begrenztes Platzangebot zur Verfügung steht, etwa in einer B- oder C-Säule eines Kraftfahrzeugs, kann dies Vorteile aufweisen. Es sollte jedoch verstanden werden, dass auch wenn eine oder mehrere Spulen gegenüber der Spulenebene verkippt sind, eine Komponente des von diesen Spulen erzeugten elektromagnetischen Felds in der Spulenebene liegen kann und es deshalb möglich ist, das rotierende elektromagnetische Feld vergleichbar zu dem Fall, in dem alle Spulen innerhalb der Spulenebene liegen, auszusenden. Insbesondere kann das rotierende elektromagnetische Feld derart ausgesendet werden, dass es eine konstante Winkelgeschwindigkeit innerhalb der Rotationsebene aufweist. Es wäre möglich, dass das rotierende em Feld eine Abhängigkeit der Feldstärke vom Winkel aufweist.

Erfindungsgemäss ist die Spulenanordnung integriert gefertigt durch Leiterbahnen auf einer Leiterplatte. Eine solche integrierte Ausführungsform kann auch als laterale oder planare Strukturierung bezeichnet werden.

Es ist möglich, dass die Leiterplatte parallel oder im Wesentlichen parallel mit der Spulenebene liegt. Die Leiterbahnen können eine zu obiger Ausführungsform vergleichsweise geringe Ausdehnung senkrecht zur Spulenebene aufweisen, etwa wenige 10 µm oder weniger als 1 mm. Dies kann Vorteile bei begrenztem Bauraum aufweisen. Das ferromagnetische Spulenjoch kann durch die Aussparungen fixiert sein.

Es ist möglich, dass pro Spule zwei oder mehr Spulenwicklungen jeweils mit einer Anzahl an Windungen vorhanden sind, die gemeinsam oder getrennt angesteuert werden können und dass die Spulenanordnung weiterhin mindestens drei weitere Kondensatoren, die jeweils parallel zu einer der zwei oder mehr Spulenwicklungen pro Spule geschaltet sind, umfasst. Derart kann es möglich sein, in einer Spule mehrere getrennt elektrisch kontaktierbare Spulenwicklungen und daher unterschiedlichen Induktivitäten vorzuhalten. Es können daher mehrere Schwingkreise mit unterschiedlichen Resonanzfrequenzen zur Verfügung stehen. Die Spulenanordnung kann daher em Felder mit unterschiedlichen Frequenzen aussenden. Darüber hinaus kann durch Parallelschalten der weiteren Kondensatoren jeweils mit einer Spulenwicklung ein Betrieb der Spulenanordnung mit einer vergleichsweisen, insbesondere zur Serienschaltung mit Kondensatoren, geringen Leistungsaufnahme erhalten werden. Dies kann insbesondere bei Anwendungen, bei denen nur ein begrenztes Energiereservoir zur Verfügung steht, Vorteile aufweisen.

Im Allgemeinen kann es möglich sein, dass die mindestens einen Spulenwicklungen der mindestens drei Spulen jeweils gleiche Geometrien und / oder Windungen aufweisen. In anderen Worten können die mindestens drei Spulen von gleicher Art und gleichem Typ sein. Es kann daher möglich sein, mittels einer besonders einfachen Bestromung das rotierendes em Feld zu erzeugen, welches vorteilhafterweise eine konstante Winkelgeschwindigkeit der Rotation aufweist.

Voranstehend wurde vornehmlich Bezug auf eine Spulenanordnung mit mindestens drei Spulen genommen. Es ist möglich, mehrere solche Spulenanordnungen kombiniert als Ortungssystem für einen Empfänger zu betreiben.

Ein nicht erfindungsgemäßes Ortungssystem zum Bestimmen einer Position eines Identifikationsgebers für ein Kraftfahrzeug umfasst mindestens Versorgungsleitungen und zwei Spulen, die an unterschiedlichen Orten des Kraftfahrzeugs ortsfest montiert sind und eingerichtet sind, jeweils als Sender für ein elektromagnetisches Feld betrieben zu werden, wobei jede der mindestens zwei Spulen mit einer der Versorgungsleitungen gekoppelt ist. Das Ortungssystem umfasst weiterhin einen Identifikationsgeber mit einer Empfangsspule, wobei der Identifikationsgeber eingerichtet ist, als Empfänger für die mindestens zwei elektromagnetischen Felder betrieben zu werden, und ein Steuergerät, welches eingerichtet ist, um die mindestens zwei Spulen über eine Rechnereinheit über ein Bussystem mit einer vorgegebenen Abfolge zum Erzeugen des jeweiligen elektromagnetischen Felds anzusteuern.

Ein solches Ortungssystem kann den Effekt einer besonders einfachen Systemarchitektur aufweisen; z.B. kann es möglich sein, die Rechnereinheiten der mindestens zwei Spulen an ohnehin im Kraftfahrzeug vorhandene Versorgungsleitungen bzw. das ohnehin vorhandene Bussystem anzuschließen. Die Ansteuerung der Spulen kann über die Rechnereinheiten erfolgen, die in der Nähe der Spulen angeordnet sein können und mit dem Bussystem und der Versorgungsleitung, sowie der jeweiligen Spule gekoppelt sein können. Die Spulenanordnung kann eine Wechselspannungsquelle umfassen, die mit der Versorgungsleitung, etwa einem 12 V Gleichspannungsnetz, verbunden ist. Insbesondere kann eine Notwendigkeit entfallen, Versorgungsleitungen zu den Spulen von einem zentralen Steuergerät vorzusehen. Bei den elektromagnetischen Feldern des Ortungssystems gemäß dem gegenwärtig diskutierten Aspekt kann es sich um herkömmliche nicht rotierende Felder handeln.

Im Allgemeinen ist dem Fachmann der Betrieb eines Ortungssystems gemäß dem gegenwärtig diskutierten Aspekt bekannt, sodass hier keine weiteren Details genannt werden müssen. Es sollte verstanden werden, dass gegenüber den vorbekannten Ortungssystemen, erfindungsgemäß der Effekt einer besonders einfachen Ansteuerung und Kontrolle durch das separate Vorhalten von Bussystem und Versorgungsleitung, etwa einem Kraftfahrzeug-Gleichspannungsnetz erreicht werden kann.

Gemäß einem weiteren Aspekt betrifft die Erfindung ein Ortungssystem zum Bestimmen einer Position eines Identifikationsgebers für ein Kraftfahrzeug, wobei das Ortungssystem mindestens zwei Spulenanordnungen der Erfindung umfasst, wobei die mindestens zwei Spulenanordnungen an unterschiedlichen Orten des Kraftfahrzeugs ortsfest montiert sind und eingerichtet sind, jeweils als Sender für ein rotierendes elektromagnetisches Feld betrieben zu werden. Das Ortungssystem umfasst weiterhin den Identifikationsgeber mit einer Empfangsspule, wobei der Identifikationsgeber eingerichtet ist, als Empfänger für die mindestens zwei rotierenden elektromagnetischen Felder betrieben zu werden.

Zum Beispiel kann das Ortungssystem eingerichtet sein, um die Position des Identifikationsgebers in einem Außenraum, d.h. einer Umgebung bzw. Umfeld, des Kraftfahrzeugs zu bestimmen. Alternativ oder zusätzlich kann das Ortungssystem eingerichtet sein, um die Position in einem Innenraum des Kraftfahrzeugs zu bestimmen.

Zum Beispiel kann also eine Frequenz der Empfangsspule abgestimmt sein auf die Frequenzen der mindestens zwei Spulenanordnungen. Es können vorzugsweise z.B. drei oder vier Spulenanordnungen vorgesehen sein. Die Spulenanordnungen können gegeneinander beabstandet montiert sein.

Durch die Verwendung von mindestens zwei Spulenanordnung bzw. mindestens zwei rotierenden elektromagnetischen Feldern kann eine besonders genaue Bestimmung der Position des Identifikationsgebers erfolgen. Zum Beispiel kann es möglich sein, über die Bestimmung einer Referenzphase gegenüber den mindestens zwei rotierenden elektromagnetischen Feldern und einer Triangulierung basierend auf den bestimmten mindestens zwei Differenzphasen eine genaue Bestimmung der Position des Identifikationsgebers innerhalb einer Rotationsebene der elektromagnetischen Felder zu erreichen.

Das Ortungssystem kann weiterhin ein Steuergerät umfassen, welches eingerichtet ist, die mindestens zwei Spulenanordnungen zum Aussenden des jeweiligen rotierenden elektromagnetischen Felds in einer vorgegebenen Abfolge anzusteuern.

Das Steuergerät kann z.B. eine zentrale Rechnereinheit des Kraftfahrzeugs sein. Z.B. kann das Steuergerät als Hardware oder Software oder eine Kombination darauf auf der zentralen Rechnereinheit des Kraftfahrzeugs implementiert sein.

Es ist möglich, dass das Steuergerät über ein Bussystem mit den mindestens zwei Spulenanordnungen gekoppelt ist und dass jede der mindestens zwei Spulenanordnungen mit einer Versorgungsleitung gekoppelt ist und dass jede der mindestens zwei Spulenanordnungen eingerichtet ist, um ein Steuersignal des Steuergeräts über das Bussystem zu empfangen und in Abhängigkeit des Steuersignals das rotierende elektromagnetische Feld zu erzeugen, wobei die Energie zum Aussenden des rotierenden elektromagnetischen Felds über die Versorgungsleitung erhalten wird.

Z.B. können die Spulenanordnungen eine Rechnereinheit als Schnittstelle zur Kommunikation mit dem Steuergerät über das Bussystem umfassen. Die Rechnereinheit kann eingerichtet sein, das Steuersignal zu empfangen und zu verarbeiten.

Die Versorgungsleitung kann z.B. ein Bordnetz eines Kraftfahrzeugs sein. Die Versorgungsleitung kann z.B. andere Strom-Spannungs-Verhältnisse aufweisen, als zur Ansteuerung der Spulen der Spulenanordnungen zum Erzeugen des rotierenden em Feldes nötig ist. Z.B. kann die Versorgungsleitung eine 12 V Gleichspannung zur Verfügung stellen. Daher können die Spulenanordnungen einen Schaltkreis zur Strom-Spannungs-Wandlung aufweisen, also eine Wechselspannungsquelle. Derart kann es z.B. möglich sein, die Spulenanordnungen dezentral mit Energie zur Erzeugung des rotierenden em Felds zu versorgen. Als Effekt kann eine vereinfachte Systemarchitektur erzielt werden - insbesondere kann es entbehrlich sein, dedizierte Versorgungsleitungen von dem Steuergerät zu den einzelnen Spulenanordnungen vorzuhalten. Die Spulenanordnungen können als Reaktion auf eine Anweisung des Steuergeräts über das Bussystem selektiv Energie aus dem Bordnetz entnehmen um das rotierende em Feld zu erzeugen. Typischerweise sind Versorgungsleitungen des Bordnetzes ohnehin in verschiedenen Bereichen des Kraftfahrzeugs vorhanden, sodass keine größeren baulichen Veränderungen notwendig sein können.

Es ist möglich, dass das Steuergerät eingerichtet ist, um die mindestens zwei Spulenanordnungen derart anzusteuern, dass sie sequentiell das jeweilige rotierende elektromagnetische Feld aussenden.

Eine sequentielle Ansteuerung kann auch als Zeit-Multiplexen bezeichnet werden; in anderen Worten, können die elektromagnetischen Felder zu verschiedenen Zeiten, etwa nacheinander, ausgesendet werden. Dies kann z.B. durch entsprechend ausgestaltete Steuersignale geschehen: die Schnittstelle der Spulenanordnungen kann die Steuersignale dekodieren und abhängig von den Steuersignalen zeitversetzt das jeweilige em Feld aussenden. Dann kann es möglich sein, lediglich ein einzelnes Steuersignal über das Bussystem auszusenden, welches den mehreren Spulenanordnungen befiehlt, zu unterschiedlichen Zeitpunkten das em Feld auszusenden. Dies wird nachfolgend erläutert: Verschiedene Ausführungsformen bezüglich der Steuerung der Spulenanordnungen durch das Steuergerät sind möglich; die Erfindung ist diesbezüglich nicht besonders beschränkt. Zum Beispiel ist es möglich, dass das Steuergerät einen einzelnen Steuerbefehl über das Bussystem sendet, welcher bei Erhalt in den Spulenanordnungen einen Zeitgeber initiiert, nach dessen Ablauf die jeweilige Spulenanordnung für eine möglicherweise ebenfalls in der Steuereinrichtung enthaltene Zeitdauer das rotierende elektromagnetische Feld aussendet. Die jeweiligen Parameter des Zeitgebers können von Spulenanordnung zu Spulenanordnung unterschiedlich sein und vom Steuergerät vorgegeben werden. Derart kann es zum Beispiel insbesondere möglich sein, dass die Sequenz, mit der die mindestens zwei Spulenanordnungen das rotierende elektromagnetische Feld aussenden, variiert wird, zum Beispiel für unterschiedliche Kraftfahrzeuge oder auch für ein einzelnes Kraftfahrzeug als Funktion der Zeit. Es ist zum Beispiel auch möglich, dass die Reihenfolge, mit der die mindestens zwei Spulenanordnungen das rotierende elektromagnetische Feld aussenden, zufällig ist. In solchen Ausführungsformen kann eine Sicherheit gegenüber böswilligen Eingriffen von dritten in das Ortungssystem erhöht werden.

Das Ortungssystem kann weiterhin mindestens eine Wechselspannungs-Quelle umfassen, die mit den mindestens zwei Spulenanordnungen und einer Versorgungsleitung verbunden ist und eingerichtet ist, um zum Erzeugen des jeweiligen rotierenden elektromagnetischen Felds jeweils die mindestens zwei Spulen jeder Spulenanordnung mit einer Wechselspannung zu versorgen. Die Wechselspannungen der mindestens zwei Spulen können in einer vorgegebenen Phasenbeziehung zueinander stehen, wobei die Phasenbeziehung benachbarter Spulen in Abhängigkeit eines Winkels vorgegeben sein kann, den diese benachbarten Spulen innerhalb einer Spulenebene miteinander einschließen.

Die mindestens eine Wechselspannungsquelle kann z.B. eine geeignete Stromquelle sein, die einen bestimmten Strom durch die Spulen der Spulenanordnungen bewirkt. Es ist z.B. möglich, dass eine Verbindung mit einem Gleichspannungs-Bordnetz des Kraftfahrzeugs vorliegt.

Zum Beispiel kann bei einem bestimmten Winkel zwischen benachbarten Spulen einer Spulenanordnung die Phasenbeziehung der Wechselspannung gleich diesem bestimmten Winkeln gewählt werden. In einer bestimmten Ausführungsform, in der drei Spulen einer Spulenanordnung jeweils Winkel von 120° zueinander einschließen, kann daher die Phasenbeziehung der Wechselspannungen, mit der die drei Spulen versorgt werden, auch 120° betragen.

Es ist z.B. möglich, dass eine erste der mindestens zwei Spulenanordnungen im Bereich einer linksseitigen B-Säule des Kraftfahrzeugs verbaut ist, dass eine zweite der mindestens zwei Spulenanordnungen im Bereich einer rechtsseitigen B-Säule des Kraftfahrzeugs verbaut ist, und dass eine dritte der mindestens zwei Spulenanordnungen im Bereich eines Hecks des Kraftfahrzeugs verbaut ist.

In einer solchen Konfiguration kann z.B. eine besonders genaue Bestimmung der Position des Identifikationsgebers erfolgen. Dies kann der Fall sein, da eine Differenzphase gegenüber einer Referenzphase an verschiedenen Positionen im Umfeld und im Innenraum des Kraftfahrzeugs für die durch solche drei Sender erzeugten rotierenden em Felder besonders unterschiedliche Werte annehmen kann. Zum Beispiel kann deshalb bei einer auf den Differenzphasen basierenden Triangulation dadurch ein geringer Fehler erhalten werden. In anderen Worten kann eine Triangulation der Differenzphasen für große Abstände/Winkel zwischen den Spulenanordnungen besonders genau sein.

Es ist insbesondere möglich, dass die mindestens zwei Spulenanordnungen derart angeordnet sind, dass Rotationsebenen der mindestens zwei rotierenden elektromagnetischen Felder im Wesentlichen parallel zueinander sind. Alternativ oder zusätzlich ist es möglich, dass die mindestens zwei Spulenanordnungen in einem Bereich von 70 cm bis 130 cm über dem Boden verbaut sind.

Zum Beispiel kann die Rotationsebene durch mindestens zwei Spulen einer Spulenanordnung aufgespannt werden (Spulenebene). Durch entsprechende geometrische Anordnung der verschiedenen Spulen der mindestens zwei Spulenanordnungen kann daher erreicht werden, dass die Rotationsebenen im Wesentlichen parallel zueinander sind. Im Wesentlichen parallel kann z.B. bedeuten: ±20°, vorzugsweise ±5°, besonders vorzugsweise ±1°.

Es ist jedoch im Allgemeinen auch möglich, dass die Rotationsebenen der verschiedenen Spulenanordnungen einen geringen oder einen größeren Winkel miteinander einschließen. Ist dieser Winkel zum Beispiel vorgegeben und baulich bekannt, so kann dies bei der Bestimmung der Position des Identifikationsgebers berücksichtigt und ggf. herausgerechnet werden. Eine Triangulation kann dies berücksichtigen.

Typischerweise kann es möglich sein, eine besonders große Genauigkeit der Bestimmung der Position des Identifikationsgebers für Positionen innerhalb der Rotationsebene des rotierenden elektromagnetischen Felds zu erhalten. Deshalb kann es erstrebenswert sein, dass die drei Spulenanordnungen und damit die Rotationsebene in einem entsprechenden Bereich über dem Boden verbaut sind. Insbesondere kann es diesbezüglich möglich sein, dass die Rotationsebene parallel oder im Wesentlichen parallel zu dem Boden liegt. Da in einem solchen Bereich über dem Boden typischerweise der Identifikationsgeber des Kraftfahrzeugs angeordnet ist, wenn er sich zum Beispiel in einer Jackentasche oder einem Aktenkoffer eines Benutzers des Kraftfahrzeugs befindet, kann derart eine einfache und genaue Bestimmung der Position erfolgen.

Gemäß einem weiteren Aspekt betrifft die Erfindung ein Kraftfahrzeug mit einem Ortungssystem zum Bestimmen einer Position eines Identifikationsgebers für ein Kraftfahrzeug, wobei das Ortungssystem des Kraftfahrzeugs mindestens zwei Spulenanordnungen gemäß der Erfindung umfasst, wobei die mindestens zwei Spulenanordnungen an unterschiedlichen Orten des Kraftfahrzeugs ortsfest montiert sind und eingerichtet sind, jeweils als Sender für ein rotierendes elektromagnetisches Feld betrieben zu werden. Das Ortungssystem des Kraftfahrzeugs umfasst weiterhin den Identifikationsgeber mit einer Empfangsspule, wobei der Identifikationsgeber eingerichtet ist, als Empfänger für die mindestens zwei rotierenden elektromagnetischen Felder betrieben zu werden.

Ein nicht erfindungsgemässes Verfahren zum Bestimmen einer Position eines Empfängers umfasst das Aussenden mindestens eines elektromagnetischen Feldes jeweils durch einen Sender, wobei eine Amplitude des mindestens einen elektromagnetischen Feldes jeweils als Funktion der Zeit gegenüber dem jeweiligen Sender rotiert. Das Verfahren betrifft weiterhin das Messen des mindestens einen elektromagnetischen Feldes durch den Empfänger und das Ermitteln einer Differenzphase für jedes des mindestens einen elektromagnetischen Felds an der Position des Empfängers basierend auf dem gemessenen mindestens einen elektromagnetischen Feld. Das Verfahren umfasst weiterhin das Bestimmen der Position des Empfängers basierend auf der mindestens einen ermittelten Differenzphase.

Das elektromagnetische Feld kann ein zeitabhängiges elektromagnetisches Wechselfeld mit einer bestimmten Frequenz sein. Die Frequenz kann z.B. in einem Bereich von 100 kHz bis 10 MHz, vorzugsweise bis 1 MHz liegen, und besonders vorteilhaft 125 kHz oder 1 MHz betragen. Der Sender kann z.B. einen elektromagnetischen Schwingkreis mit einer Induktivität und einem Kondensator umfassen; dem Fachmann sind diesbezüglich Techniken bekannt, welche entsprechende Ausgestaltung des Senders zum Erzeugen dieser Frequenzen ermöglichen.

Das elektromagnetische (em) Feld kann z.B. als rotierendes em Feld bezeichnet werden, da die Amplitude zeitabhängig in einer Rotationsebene um den Sender rotieren kann, also eine Rotationsbewegung mit einer Winkelgeschwindigkeit durchführen kann. In anderen Worten können Punkte gleicher Phasenlage, also z.B. ein Maximum oder Minimum der Feldstärke des em Felds, zeitabhängig jeweils unter unterschiedlichen Richtungen oder Winkeln gegenüber dem Sender angeordnet sein. Bildlich gesprochen kann sich z.B. ein Feldstärkemaximum wie der Lichtstrahl eines Leuchtturms (hier der Sender) bewegen. Insbesondere kann eine Rotationsfrequenz der Rotationsbewegung gleich der Frequenz des em Felds selbst sein. Es ist aber auch möglich, dass die Rotationsfrequenz andere Werte annimmt. Die Rotationsbewegung des em Felds kann (wie es typisch für zyklische Abläufe ist) durch eine bestimmte Phase (Phasenlage) der Bewegung charakterisiert werden; eine volle Rotation kann einer akkumulierten Phase von 360° bzw. 2π entsprechen. Das rotierende em Feld kann sich z.B. mit einer konstanten Winkelgeschwindigkeit bewegen. Im Allgemeinen sind auch bestimmte vorgegebene Abhängigkeiten der Winkelgeschwindigkeit von der Phase (dem Winkel) möglich. Z.B. kann es möglich sein, dass die Rotationsebene parallel oder im Wesentlichen parallel, d.h. z.B. kleiner ±20°, vorzugsweise kleiner ± 10°, besonders vorzugsweise kleiner ± 2°, mit der Horizontalen ausgerichtet ist, also z.B. im Wesentlichen parallel mit einem Boden ist. Das rotierende em Feld kann mit einer Spulenanordnung gemäß einem weiteren Aspekt der Erfindung erzeugt werden.

Durch die Rotationsbewegung des ausgesendeten em Feldes kann sich eine entsprechende Zeitabhängigkeit der Feldstärke bzw. der Phasenlage des em Felds am Ort des Empfängers ergeben. Der Empfänger kann insbesondere eingerichtet sein, um die Feldstärke des em Felds zeitabhängig und / oder frequenzaufgelöst messen - dazu kann der Empfänger z.B. eingerichtet sein, um eine Amplitude der magnetischen Feldkomponente des em Felds zu messen, die wiederum proportional zu einer Feldstärke des em Felds sein kann. Es kann dann möglich sein, die Differenzphase aus der Messung der Feldstärke zu bestimmen; z.B. gegenüber einer Referenzphase, welche insbesondere aus der Phase des em Felds am Sender beim Aussenden bestimmt werden kann.

Als spezielles illustratives und nicht als limitierend auszulegendes Beispiel hierzu sei folgende Situation beschrieben: bei einer Phasenlage von 0° sendet der Sender das em Feld so aus, dass es nach Osten zeigt (beliebig definiert). Der Empfänger befindet sich aber im Süden des Senders und "sieht" daher das Maximum (noch) nicht. Erst bei einer Phase von 90° am Sender erreicht das Maximum der Amplitude den Empfänger (wenn sich das rotierende em Feld im Uhrzeigersinn dreht). Die Differenzphase kann daher in diesem Beispiel mit -90° angegeben werden. Ein entsprechendes Beispiel kann natürlich auch für Werte des em Felds anders als das Maximum der Amplitude dargestellt werden. Z.B. kann dies ein bestimmtes Trigger-Level der Amplitude betreffen, welches hinsichtlich der auf- oder absteigenden Flanke definiert ist.

Es ist natürlich im Allgemeinen genauso möglich, die Differenzphase gegenüber einer anderen Referenzphase zu bestimmen, etwa gegenüber einem System-Takt oder einem externen Triggersignal, etwa der Betätigung eines Türgriffs durch einen Benutzer oder einem erkanntem Objekt in einem Umfeldbereich oder ähnlichem. Es ist z.B. auch möglich, statt des Maximums der Amplitude oder Feldstärke ein Minimum oder einen Nulldurchgang zu betrachten, bzw. eine beliebige Phasenlage oder signifikante Punkte des zeitlichen Verlaufs der charakterisierenden Observablen. Im Allgemeinen kann eine Amplitude der magnetischen Komponente des elektromagnetischen Felds betrachtet werden oder eine Amplitude der elektrischen Komponente; beide können signifikant für die Feldstärke des em Felds sein. Jedoch kann der Sender und / oder der Empfänger mindestens eine Spule aufweisen, welche eingerichtet ist, um mit der magnetischen Komponente des elektromagnetischen Felds induktiv wechselzuwirken.

Aus der Differenzphase kann die Position des Empfängers bestimmt werden. Hierbei kann der Begriff "Position" unterschiedlichste Genauigkeiten der Positionsbestimmung bezeichnen: In einer besonders einfachen Ausführungsform kann der Begriff "Position" lediglich einen Winkel des Empfängers gegenüber dem Sender bezeichnen (in obigen Beispiel -90°). Es ist aber auch möglich, dass der Begriff "Position" zusätzlich oder alternativ zu dem Winkel gegenüber dem Sender auch einen Abstand gegenüber dem Sender bezeichnet, zum Beispiel innerhalb der Rotationsebene des em Felds. Es ist darüber hinaus möglich, dass der Begriff "Position" zusätzlich oder alternativ einen Abstand zum Beispiel gegenüber dieser Rotationsebene des em Felds, d.h. senkrecht zu der Rotationsebene, bezeichnet; in einem solchen Fall kann es insbesondere möglich sein, dass der Begriff "Position" eine absoluten Positionsbestimmung des Empfängers innerhalb eines Referenzkoordinatensystems bezeichnet; das Referenzkoordinatensystem kann im Allgemeinen beliebig gewählt werden, es kann jedoch erstrebenswert sein, es in Bezug auf den mindestens einen Sender zu definieren (dieser kann z.B. im Ursprung des Referenzkoordinatensystems angeordnet sein). Mit anderen Worten kann der Begriff "Bestimmen einer Position" das Bestimmen einzelner Koordinaten des dreidimensionalen Raums, etwa Abstand und / oder Azimutwinkel und / oder Polarwinkel eines Kugelkoordinatensystems, oder aber alle Koordinaten des dreidimensionalen Raums bezeichnen.

Zum Beispiel kann es in verschiedenen Ausführungsformen erstrebenswert sein, eine besonders genaue Bestimmung der Position des Empfängers durchzuführen. Eine besonders genaue Bestimmung der Position des Empfängers kann insbesondere das Bestimmen von mehreren oder allen Koordinaten des dreidimensionalen Raums umfassen. Insbesondere in einem solchen Fall kann es möglich sein, mehr als ein, zum Beispiel zwei oder drei, elektromagnetische Felder durch mehrere Sender, zum Beispiel also zwei oder drei Sender, auszusenden. In anderen Worten kann es einen Sender pro Feld geben. Es können dann mehrere Differenzphasen bestimmt werden, z.B. jeweils gegenüber dem von den mehreren Sendern ausgesendeten em Felder, und unter Berücksichtigung der mehreren Differenzphasen die Position des Empfängers besonders genau bestimmt werden.

In verschiedenen Ausführungsformen kann es möglich sein, dass mehrere em Felder zeitgleich mit verschiedenen Frequenzen ausgesendet werden, sog. Frequenz-Multiplexen. Es kann dann möglich sein, dass der Empfänger ausgestaltet ist, die mehreren em Felder bei den verschiedenen Frequenzen zu messen. Frequenz-Multiplexen kann den Effekt einer besonders schnellen Bestimmung der Position aufweisen. Zum Aussenden der zwei oder mehr rotierenden em Felder kann z.B. ein Ortungssystem gemäß dem oben-genannten Aspekt der Erfindung verwendet werden.

Es ist möglich, dass das Aussenden für zwei oder mehr elektromagnetische Felder sequentiell geschieht und dass das Messen für die zwei oder mehr elektromagnetischen Felder sequentiell geschieht. Das Bestimmen der Position des Empfängers kann basierend auf einer Triangulation für die mindestens zwei Differenzphasen geschehen und das Bestimmen der Position des Empfängers kann das Bestimmen einer Richtung und Entfernung, unter der der Empfänger in einer Rotationsebene des zeitabhängigen elektromagnetischen Felds gegenüber mindestens einem der Sender angeordnet ist, umfassen. Ein solcher Fall kann auch als Zeit-Multiplexen bezeichnet werden, da die mehreren em Felder sequentiell, also nacheinander bzw. zu unterschiedlichen Zeiten, gesendet werden. Es können dann mehrere Differenzphasen aus den mehreren gemessenen em Feldern bekannt sein und die Triangulation kann eine besonders genaue Bestimmung der Position, insbesondere auch des Abstandes zu einem oder mehreren Sendern ermöglichen. Die Triangulation kann im Allgemeinen das Bestimmen der Position basierend auf den gemessenen Differenzphasen und einer bekannten Anordnung der mehreren Sender zueinander bedeuten. Techniken zur Triangulation sind dem Fachmann grundsätzlich bekannt, sodass hier keine weiteren Details erläutert werden müssen.

Es kann insbesondere möglich sein, die Position in einem Referenzkoordinatensystem zu bestimmen, in dem auch eine Position der Sender bekannt ist. Insbesondere kann es nämlich möglich sein, dass die Sender ortsfest, z.B. in Bezug auf das Referenzkoordinatensystem angeordnet sind, und der Empfänger beweglich angeordnet ist. Z.B. kann die Richtung als Azimutwinkel in einem Referenzkoordinatensystem mit Kugelkoordinaten angegeben sein, dessen Ursprung einer der Sender bildet. Andere Definitionen sind möglich.

Solche Techniken, welche das Aussenden von zwei oder mehr em Feldern beinhalten, können eine besonderes genaue Bestimmung der Position des Empfängers erlauben bzw. sie können es erlauben, zwei oder drei Koordinaten der Position des Empfängers zu bestimmen. Die bestimmte Position kann z.B. auf einem Display für einen Benutzer dargestellt werden. Dies kann auch ein einfaches Auffinden des Empfängers ermöglichen. Insbesondere kann durch Anwenden der Techniken der Triangulation der Effekt der genauen Positionsbestimmung erreicht werden. Es sollte verstanden werden, dass das Ermitteln einer Differenzphase für die rotierenden em Felder vergleichsweise genau geschehen kann, d.h. einen vergleichsweise geringen Fehler aufweisen kann - insbesondere im Vergleich zu herkömmlichen Techniken, welche auf einer Messung der Feldstärke des em Felds beruhen und bei denen die Positionsbestimmung auf einer Dämpfungsrate der Amplitude des em Felds basieren. Insbesondere kann es in verschiedenen Ausführungsformen nicht notwendig sein, diese Dämpfungsrate der Amplitude des em Felds überhaupt zu berücksichtigen - deshalb kann es in verschiedenen Ausführungsformen auch entbehrlich sein, die Dämpfungsrate der Feldstärke des em Felds in einer eingangs beschriebenen Kalibrationsmessung zu erfassen. Dies kann Kosten für die Durchführung des Verfahrens zum Bestimmen der Position des Empfängers senken. Es sollte jedoch verstanden werden, dass es alternativ oder zusätzlich auch möglich ist, die Dämpfungsrate der Feldtstärke des em Felds zu berücksichtigen. Dies kann nämlich eine besonders große Genauigkeit in der Positionsbestimmung ermöglichen. Insbesondere können die zwei oder mehr em Felder derart ausgesendet werden, dass sie alle in einer Rotationsebene rotieren.

Das Verfahren kann weiterhin das Ermitteln einer Feldstärke für das mindestens eine elektromagnetische Feld in der Position des Empfängers basierend auf dem gemessenen mindestens einen elektromagnetischen Feld umfassen, wobei das Bestimmen der Position des Empfängers das Bestimmen eines Abstandes des Empfängers zu einer Rotationsebene des elektromagnetischen Felds basierend auf der ermittelten Feldstärke umfasst.

Es kann basierend auf der Feldstärke, z.B. qualitativ oder quantitativ, bestimmt werden, ob sich der Empfänger oberhalb oder unterhalb der Rotationsebene befindet. Dazu kann insbesondere eine Spule als Sender vorgesehen sein, welche einen bestimmten Winkel mit der durch die übrigen Spulen aufgespannten Ebene einschließt. Ist nämlich der Empfänger gegenüber der Rotationsebene beabstandet, so können bei gleicher Position innerhalb der Rotationsebene (Abstand zum Sender, Winkel zum Sender) größere bzw. kleinere Entfernungen zur Rotationsebene kleinere bzw. größere Feldstärken bewirken. Als Maß für die Feldstärke kann z.B. die Amplitude der Magnetfeldkomponente verwendet werden. Es kann alternativ oder zusätzlich auch erstrebenswert sein, basierend auf der Feldstärke einen Abstand des Empfängers lediglich oberhalb der Rotationsebene zu bestimmen. Dies kann der Fall sein, wenn die Sender einen geringen Abstand gegenüber dem Boden aufweisen und der Empfänger daher notwendigerweise nach oben gegenüber der Rotationsebene beabstandet ist.

Das Verfahren kann weiterhin das Modulieren des mindestens einen elektromagnetischen Felds zum Übertragen von Information an den Empfänger umfassen, wobei die Information Elemente umfasst, die aus folgender Gruppe ausgewählt werden: eine Taktinformation einer Referenzphase, eine Identifizierungsinformation des mindestens einen Senders.

Hierbei kann es möglich sein, Modulationstechniken zu verwenden, welche aus folgender Gruppe ausgewählt sind: Frequenzmodulation (FM), Phasenmodulation (PM), "Frequency Shift Keying" (FSK), "Phase Shift Keying" (PSK), Pulsamplitudenmodulation (PAM), Pulse-Code-Modulation (PCM). Im Allgemeinen sind weitere Modulationstechniken, wie sie dem Fachmann grundsätzlich bekannt sind, möglich.

Die Identifizierungsinformation kann z.B. eine Information über eine Position des jeweiligen Senders umfassen. Diese Positionsinformation kann z.B. angeben, wo in Bezug auf das Kraftfahrzeug sich der jeweilige Sender befindet, etwa "rechts vorne" oder "links" oder "hinten recht" usf. Es ist z.B. möglich diese Positionsinformation explizit zu übertragen oder aber als Code parametrisiert, der sich z.B. über eine z.B. im Empfänger hinterlegte Tabelle den Positionen zuordnen lässt.

Im Allgemeinen ist es möglich, dass bei mehreren ausgesendeten elektromagnetischen Feldern die verschiedenen ausgesendeten elektromagnetischen Felder unterschiedliche Modulationstechniken und/oder Modulationsfrequenzen aufweisen. Es ist auch möglich, dass die verschiedenen em Felder gleiche Modulationstechniken, aber unterschiedliche Modulationsfrequenzen aufweisen. Es ist auch möglich, Modulationstechnik und Modulationsfrequenz gleich für alle em Felder zu wählen. Die übertragene Information kann sich jeweils unterscheiden.

Es ist z.B. möglich, dass jedes rotierende em Feld durch eine Vielzahl, z.B. drei oder vier, em Felder, die von einzelnen Spulen unter einer vorgegebenen Phasenbeziehung ausgesendet werden, erzeugt wird. Diese das rotierende em Feld erzeugenden em Felder können wiederum unterschiedlich moduliert sein, z.B. um unterschiedliche Information zu übertragen.

Je nach Anwendungsfall des Verfahrens zum Bestimmen der Position des Empfängers kann eine bestimmte Modulationstechnik und/oder Modulationsfrequenz bevorzugt werden - zum Beispiel kann die Modulationstechnik bei einer Anwendung zum Bestimmen der Position eines Kraftfahrzeugsschlüssels unterschiedlich gewählt sein gegenüber einer Anwendung zur Ortung von Personen in einem Gebäuderaum.

Es kann insbesondere möglich sein, dass das Ermitteln der Differenzphase weiterhin auf der Taktinformation der Referenzphase basiert. Z.B. kann die Differenzphase gegenüber der Referenzphase ermittelt werden. Hierbei kann die Taktinformation je nach Ausführungsform unterschiedlichen Informationsgehalt aufweisen: In einer besonders einfachen Ausführungsform ist es möglich, dass die Taktinformation lediglich einen Nulldurchgang (bzw. ganzzahlige Vielfache von 360°) der Referenzphase indiziert. In verschiedenen anderen Ausführungsformen kann es jedoch möglich sein, dass die Referenzphase zeitaufgelöst über die Taktinformation übertragen wird. Derart kann es möglich sein, in einem Bruchteil einer Rotation des em Felds die aktuelle Phasenlage bzw. Referenzphase zu bestimmen. Es ist natürlich auch möglich, die Referenzphase in bestimmten Schritten, zum Beispiel in Intervallen von π/2 oder π/4 oder π/8 etc. zu übertragen.

Die Identifizierungsinformation kann z.B. bei Anwendungen verwendet werden, welche eine Authentifizierung des Empfängers umfassen. Z.B. kann bei der Positionsbestimmung eines Kraftfahrzeugschlüssels die Identifizierungsinformation des mindestens des Kraftfahrzeugs mit einer Identifizierungsinformation des Empfängers abgeglichen werden, um unautorisierten Zugang zu verhindern.

Es kann möglich sein, dass ein Zusammenhang zwischen der Frequenz des em Felds und der Abklingrate der Feldstärke besteht. Deshalb kann es möglich sein, je nach Frequenz des em Felds, unterschiedlich große Bereiche, in denen die Positionsbestimmung erfolgen kann, zu realisieren - solche Bereiche können über eine Feldstärke des em Felds bestimmt sein, die größer als ein Schwellenwert ist (sensitive Bereiche), sodass insbesondere ein Signal-zu-Rausch Verhältnis in der Messung des em Felds groß genug ist. In verschiedenen Frequenzbereichen, etwa den obenstehend genannten Frequenzbereichen, kann eine höhere (niedrigere) Frequenz eine geringere (größere) Abklingrate der Feldstärke bewirken und daher einen größeren (kleineren) sensitiven Bereich ermöglichen. Nachfolgend wird erläutert, wie in verschiedenen Ausführungsformen das Verfahren zur Positionsbestimmung gemäß dem gegenwärtigen Aspekt diese Erkenntnis nutzbar machen kann.

Gemäß einem weiteren Aspekt betrifft die Erfindung ein Verfahren zum Bestimmen einer Position eines Identifikationsgebers für eine Zugangskontrolle zu einem Kraftfahrzeug, welches gemäß dem Verfahren zum Bestimmen einer Position eines Empfängers gemäß einem weiteren Aspekt der Erfindung konfiguriert ist.

Zum Beispiel kann der Identifikationsgeber ein Schlüssel des Kraftfahrzeugs sein. Es ist insbesondere möglich, dass Identifizierungsinformation, welche zum Beispiel durch das Modulieren des elektromagnetischen Felds zu dem Identifikationsgeber übertragen wird, mit einer Identifizierungsinformation des Identifikationsgeber verglichen wird. Dies kann der Authentifizierung bzw. Zugangskontrolle dienen.

Für ein solches Verfahren zum Bestimmen der Position des Identifikationsgebers können Effekte erzielt werden, welche vergleichsweise mit den Effekten, welche für ein Verfahren zum Bestimmen der Position des Empfängers gemäß einem weiteren Aspekt der Erfindung erzielt werden können.

Ein nicht erfindungsgemässes Ortungssystem für einen Empfänger umfasst mindestens einen Sender, der jeweils eingerichtet ist, um ein zeitabhängiges elektromagnetisches Feld auszusenden, wobei eine Amplitude des elektromagnetischen Feldes als Funktion der Zeit gegenüber dem Sender rotiert. Das Ortungssystem umfasst weiterhin den Empfänger, der eingerichtet ist, um das mindestens eine zeitabhängige elektromagnetische Felde zu messen. Das Ortungssystem umfasst weiterhin eine Rechnereinheit, die eingerichtet ist, um die folgenden Schritte durchzuführen: Ermitteln einer Differenzphase für jedes des mindestens einen elektromagnetischen Feldes an der Position des Empfängers basierend auf dem gemessenen mindestens einem zeitabhängigen elektromagnetischen Feld; und Bestimmen der Position des Empfängers basierend auf der mindestens einen ermittelten Differenzphase.

Zum Beispiel ist es möglich, dass die Rechnereinheit innerhalb des Empfängers angeordnet ist. Es ist aber auch möglich, dass die Rechnereinheit außerhalb des Empfängers angeordnet ist. Es ist auch möglich, dass Teile der Schritte der Rechnereinheit innerhalb des Empfängers durchgeführt werden, zum Beispiel das Ermitteln der Differenzphase, während andere Teile außerhalb des Empfängers durchgeführt werden, zum Beispiel das Bestimmen der Position des Empfängers. Es ist möglich, dass die Rechnereinheit bzw. Funktionen der Rechnereinheit als Hardware oder Software oder einer Kombination daraus implementiert sind und/oder auf unterschiedlichen Hardware-Einheiten ausgeführt werden.

Das Ortungssystem gemäß dem gegenwärtig diskutierten Aspekt kann weiterhin eingerichtet sein, um ein Verfahren zum Bestimmen einer Position eines Empfängers durchzuführen. Für ein solches Ortungssystem können Effekte erzielt werden, welche vergleichbar sind mit den Effekten, die für das Verfahren zum Bestimmen der Position des Empfängers erzielt werden können.

Ein nicht erfindungsgemässes Kraftfahrzeug, umfasst ein Ortungssystem für einen Empfänger, wobei das Ortungssystem mindestens einen Sender umfasst, der jeweils eingerichtet ist, um ein zeitabhängiges elektromagnetisches Feld auszusenden, wobei eine Amplitude des elektromagnetischen Feldes als Funktion der Zeit gegenüber dem Sender rotiert. Das Ortungssystem des Kraftfahrzeugs umfasst weiterhin den Empfänger, der eingerichtet ist, um das mindestens eine zeitabhängige elektromagnetische Felde zu messen. Das Ortungssystem des Kraftfahrzeugs umfasst weiterhin eine Rechnereinheit, die eingerichtet ist, um die folgenden Schritte durchzuführen: Ermitteln einer Differenzphase für jedes des mindestens einen elektromagnetischen Feldes am Ort des Empfängers basierend auf dem gemessenen mindestens einem zeitabhängigen elektromagnetischen Feld; und Bestimmen der Position des Empfängers basierend auf der mindestens einen ermittelten Differenzphase.

Die oben dargelegten Merkmale und Merkmale, die nachfolgend beschrieben werden, können nicht nur in den entsprechenden explizit dargelegten Kombination verwendet werden, sondern auch in weiteren Kombination, im Rahmen des in den Ansprüchen definierten Schutzumfangs der Erfindung. Z.B. können z.B. Merkmale und Eigenschaften, die in Bezug auf das em Feld beschrieben wurden, auf das weitere em Feld mit der weiteren Frequenz übertragen werden. Aspekte der verschiedenen Ortungssysteme können auch auf die jeweils anderen Ortungssysteme, sowie auf den Aspekt des Kraftfahrzeugs übertragen werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele/Beispiele die im Zusammenhang mit den Zeichnungen näher erläutert werden, wobei
FIG. 1 eine Aufsicht auf eine Spulenanordnung für ein Ortungssystem ist, wobei die Spulenanordnung drei Spulen mit jeweils zwei Spulenwicklungen aufweist;
FIG. 2A eine Aufsicht auf eine Spulenanordnungen wie in FIG. 1 ist, bei der eine Spule gegenüber einer Spulenebene verkippt ist;
FIG. 2B eine Seitenansicht der Spulenanordnung aus FIG. 2A ist;
FIG. 3 den Strom durch die Spulen der Spulenanordnung der FIG. 1 als Funktion der Zeit darstellt, wobei der Strom durch eine Wechselspannung erzeugt wird;
FIG. 4 ein Isokonturplot der Amplitude der magnetischen Feldkomponente des von der Spulenanordnung der FIG. 1 erzeugten elektromagnetischen Felds zu einem bestimmten Zeitpunkt ist;
FIG. 5 die Rotation des elektromagnetischen Felds der Spulenanordnung der FIG. 1 mittels der zeitlichen Evolution von Isokonturplots der Amplitude der magnetischen Feldkomponente illustriert;
FIG. 6 eine gemessene Amplitude der magnetischen Komponente des rotierenden elektromagnetischen Felds der FIG. 5 an einem zum Sender beabstandeten Punkt innerhalb der Rotationsebene als Funktion der Zeit darstellt;
FIG. 7A eine Phasenbeziehung für eine bestimmte Position des Empfängers gegenüber von durch zwei Spulenanordnungen erzeugten rotierenden elektromagnetischen Felds illustriert, wobei FIG. 7A eine Aufsicht auf eine Rotationsebene ist, in der das elektromagnetische Feld rotiert;
FIG. 7B eine Seitenansicht der FIG. 7A ist und einen Abstand des Empfängers zu der Rotationsebene des rotierenden elektromagnetischen Felds illustriert;
FIG. 8A eine elektrische Schaltung einer zwei Spulenwicklungen und zwei Kondensatoren umfassenden Spule illustriert;
FIG. 8B eine Abklingrate der Feldstärke des elektromagnetischen Felds für unterschiedliche Betriebsarten der elektrischen Schaltung der FIG. 8A bzw. für unterschiedliche Frequenzen illustriert;
FIG. 8C eine Wechselspannungs-Quelle schematisch illustriert, die mit einem Bordnetz und den Spulen der Spulenanordnung verbunden ist;
FIG. 9A eine perspektivische Ansicht der Spulenanordnung der FIG. 1 in einem Gehäuse ist;
FIG. 9B eine Aufsicht von oben auf die Spulenanordnung mit Gehäuse der FIG. 9A ist;
FIG. 9C eine Aufsicht von unten auf die Spulenanordnung mit Gehäuse der FIG. 9A ist;
FIG. 9D eine perspektivische Ansicht der Spulenanordnung der FIG. 9A ist, wobei die Spulenanordnung auf einer Leitplatte befestigt ist;
FIG. 9E eine weitere perspektivische Ansicht der Spulenanordnung der FIG. 9A ist, wobei die Spulenanordnung auf einer Leitplatte befestigt ist;
FIG. 9F eine Seitenansicht der Spulenanordnung der FIG. 9D und 9E ist;
FIG. 10A eine perspektivische Ansicht der Spulenanordnung der FIG. 1 in einer alternativen Ausführungsform des Gehäuses ist;
FIG. 10B eine Aufsicht von oben auf die Spulenanordnung mit der alternativen Ausführungsform des Gehäuse der FIG. 10A ist;
FIG. 10C eine Aufsicht von unten auf die Spulenanordnung mit der alternativen Ausführungsform des Gehäuse der FIG. 10A ist;
FIG. 10D eine perspektivische Ansicht der Spulenanordnung der FIG. 1 mit der alternativen Ausführungsform des Gehäuses ist, wobei die Spulenanordnung auf einer Leitplatte befestigt ist;
FIG. 10E eine Seitenansicht der Spulenanordnung der FIG. 1 mit der alternativen Ausführungsform des Gehäuses ist, wobei die Spulenanordnung auf einer Leitplatte befestigt ist;
FIG. 11 eine Aufsicht auf eine auf einer Leiterplatte integrierten erfindungsgemässen Ausführungsform der Spulenanordnung ist, in der die Spulen durch Leiterbahnen ausgebildet sind;
FIG. 12 eine schematische Skizze eines vorbekannten Ortungssystems für einen Identifikationsgeber eines Kraftfahrzeugs ist;
FIG. 13 eine schematische Skizze eines erfindungsgemäßen Ortungssystems für einen Identifikationsgeber eines Kraftfahrzeugs ist;
FIG. 14 eine bauliche Anordnung des Ortungssystem der FIG. 13 in dem Kraftfahrzeug darstellt; und
FIG. 15 ein Flussdiagramm eines Verfahrens zum Bestimmen einer Position eines Empfängers ist.

Nachfolgend wird die vorliegende Erfindung anhand bevorzugter Ausführungsformen und nicht erfindungsgemässer Beispiele unter Bezugnahme auf die Zeichnungen näher erläutert. In den Figuren bezeichnen gleiche Bezugszeichen gleiche oder ähnliche Elemente. Anhand der Figuren werden Techniken zur Ortung bzw. Positionsbestimmung erläutert: hierbei betreffen verschiedene Aspekte Spulen und Spulenanordnungen, die das Aussenden eines elektromagnetischen rotierenden Felds ermöglichen, sowie Ortungssysteme, welche mehrere solcher Spulenanordnungen umfassen und eine bestimmte Systemarchitektur aufweisen, als auch die grundlegenden Techniken, welche die Positionsbestimmung anhand der rotierenden Magnetfelder ermöglichen.

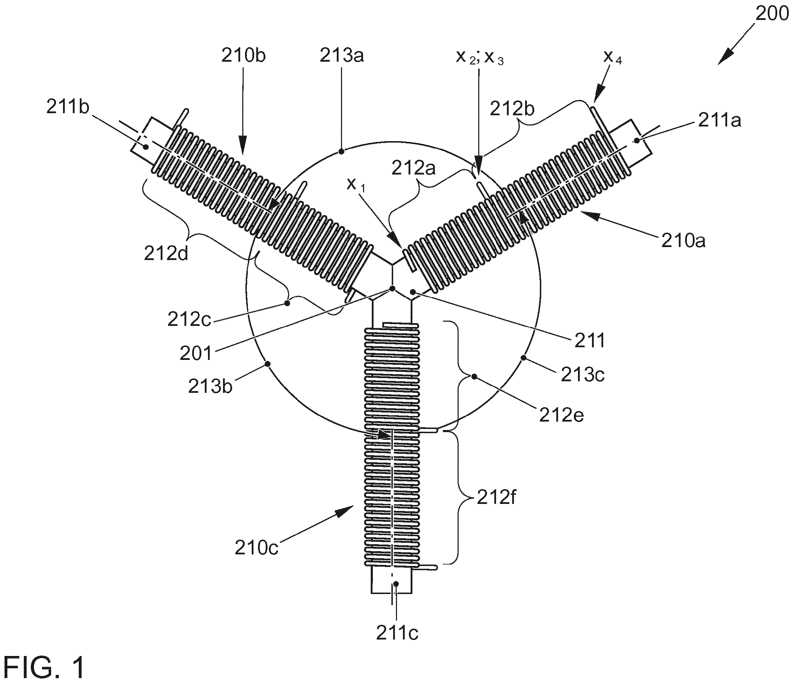

In FIG. 1 ist eine Aufsicht auf eine Spulenanordnung, die drei Spulen 210a, 210b, 210c umfasst, dargestellt. Die Spule 210a weist zwei Spulenwicklungen 212a, 212b auf. Die Spule 210b weist zwei Spulenwicklungen 212c, 212d auf. Die Spule 210c weist zwei Spulenwicklungen 212e, 212f auf. Die Spulenwicklungen 212a-212f sind jeweils um einen von drei Armen 211a, 211b, 211c eines ferromagnetischen Spulenjochs 211 gewickelt und können elektrisch separat ankontaktiert werden. Das Spulenjoch kann z.B. aus Eisen, Nickel, Chrom, Oxiden oder Legierungen aus diesen Materialien bestehen. Die Arme 211a, 211b, 211c weisen einen kreisförmigen Querschnitt auf und sind daher zylinderförmig. Sie können einen Durchmesser von 3 mm-30 mm, vorzugsweise von 6 mm aufweisen. Die Form der Arme ist variabel. Sie erstrecken sich radial von einem Zentrum der Spulenanordnung 200. Das Spulenjoch ist durchgängig und weist deshalb insbesondere keine großen Lücken oder Spalte auf - daher kann sich eine magnetische Kopplung (in Form einer ferromagnetische

Austauschwechselwirkung, die einen großen magnetischen Fluss bewirkt) zwischen den drei Spulen 210a, 210b, 210c aufbauen. Je nach gewünschter Induktivität (und damit Frequenz des elektromagnetischen Felds) kann eine unterschiedliche Windungsanzahl gewählt werden.

Der magnetische Fluss kann an verschiedenen Punkten der Spulenanordnung 200 unterschiedliche Werte annehmen. Durch die Bauform der Spulenanordnung 200 lassen sich diese Werte vorgeben. Z.B. kann in dem Zentrum der Spulenanordnung 200 der magnetische Fluss einen Wert Null oder nahe Null annehmen, d.h. einen sehr geringen Wert.

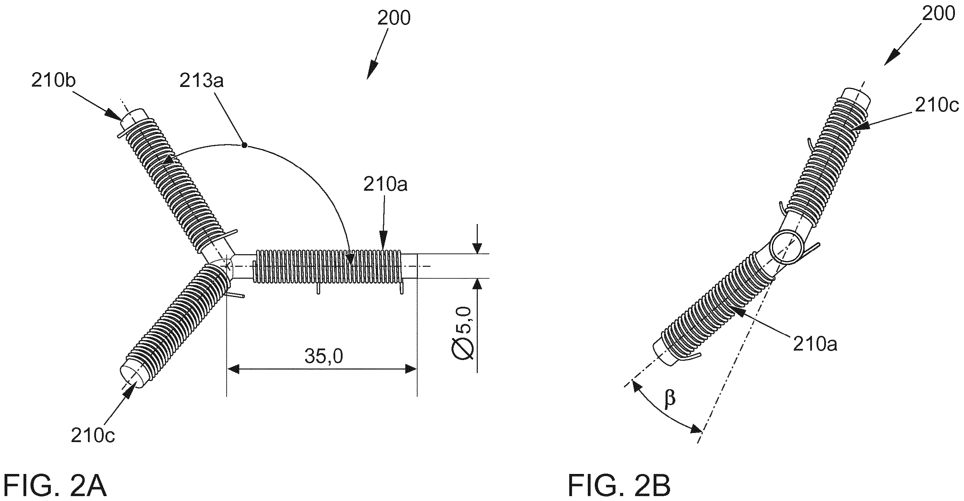

Wie aus FIG. 1 ersichtlich, liegen die Spulen 210a, 210b, 210c alle in einer Ebene. In den FIGs. 2A und 2B ist eine alternative Ausführungsform gezeigt, in der die Spule 210c gegenüber dieser Ebene (Spulenebene) um einen Winkel β verkippt ist. Dadurch kann eine geringe Abmessung der Spulenanordnung 200 in der Spulenebene erreicht werden. Der Winkel β kann z.B. in einem Bereich von 20°-30° liegen.

Wieder Bezug nehmend auf FIG. 1 schließt die Spule 210a mit der Spule 210b einen Winkel 213a ein. Die Spule 210b schließt mit der Spule 210c einen Winkel 213b ein. Die Spule 210c schließt mit der Spule 210a einen Winkel 213c ein. Diese Winkel 213a, 213b, 213c erstrecken sich jeweils innerhalb der Spuleebene. In der Ausführungsform der FIG. 1 nehmen diese Winkel 213a, 213b, 213c gleiche Werte ein, nämlich 120°. Mit anderen Worten hat die Spulenanordnung 200 der FIG. 1 eine sternförmige Konfiguration. Während in der FIG. 1 eine hochsymmetrische Ausführungsform gezeigt ist, ist es im Allgemeinen jedoch möglich, dass die verschiedenen Winkel 213a, 213b, 213c unterschiedliche Werte annehmen - dies kann insbesondere dann erstrebenswert sein, wenn eine Bauform der Spulenanordnung 200 aufgrund von baulichen Beschränkungen bestimmten Limitationen unterliegt. Die Winkel 213a, 213b, 213c sind nicht besonders limitiert und können verschiedenste Werte annehmen. Z.B. könnten die Winkel 213a - 213b - 213c jeweils folgende Werte annehmen: 180° - 90° - 90°; 200° - 80° - 80°, 160° - 100° - 100°.

Wie in FIGs. 2A und 2B gezeigt, können einzelne Spulen 210c aus der Spulenebene verkippt werden. Dadurch können die lateralen Abmessungen der Spulenanordnung 200, d.h. die Dimensionen innerhalb der von den Spulen 210a, 210b aufgespannten Spulenebene, reduziert werden. Da jedoch eine Komponente des von der Spule 210c erzeugten zeitabhängigen elektromagnetischen Felds noch innerhalb der Spulenebene liegt, kann mit der Spulenanordnung 200 der FIGs. 2A und 2B ein elektromagnetisches Feld erzeugt werden, welches mit dem elektromagnetischen Feld der Spulenanordnung 200 der FIG. 1 vergleichbar ist.

Während in den FIG. 1, 2A, 2B jeweils Fälle gezeigt sind, in denen die Spulenanordnungen 200 drei Spulen 210a, 210b, 210c umfassen, so ist es im Allgemeinen möglich, mehr Spulen zu verwenden. Zum Beispiel ist eine Ausführungsform denkbar, bei der die Spulenanordnung 200 vier (sechs) Spulen umfasst, welche jeweils innerhalb der Spulenebene einen Winkel von 90° (60°) zueinander einschließen.

Voranstehend wurde vornehmlich auf bauliche Merkmale der Spulenanordnung 200 Bezug genommen. Nachfolgend wird erläutert, wie es möglich ist, mittels solcher Spulenanordnungen 200 ein rotierendes elektromagnetisches (em) Feld zu erzeugen. Das rotierende em Feld wird durch eine Überlagerung der von den einzelnen Spulen 210a, 210b, 210c ausgesendeten em Feldern erzeugt. Das rotierende em Feld kann hierbei ein solches Feld bezeichnen, bei dem Punkte gleicher Phase des em Felds als Funktion der Zeit um die Spulenanordnung 200 (etwa deren Mittelpunkt 201, siehe FIG. 1) rotieren.

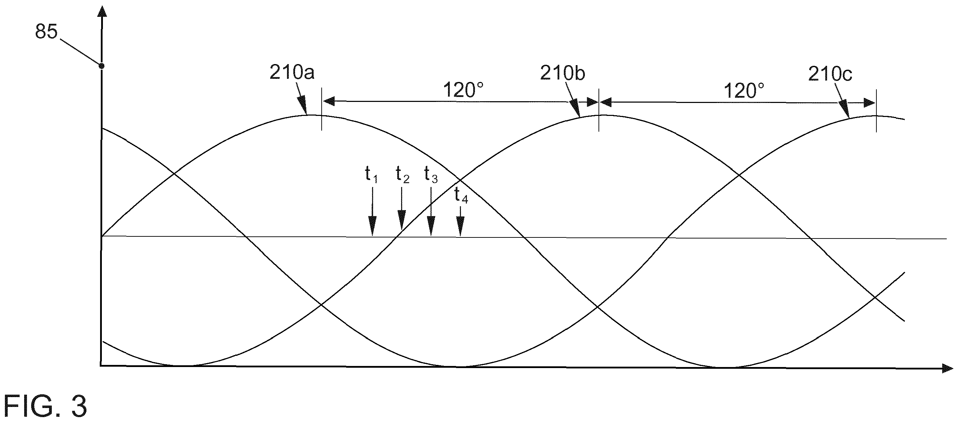

Zur Erzeugung eines em Felds werden die Spulen 210a-210c zusammen mit einem Kondensator (in FIGs. 1 - 3 nicht gezeigt) als Schwingkreis angesteuert. In Bezug auf die FIG. 3 wird zunächst eine Ausführungsform diskutiert, bei dem die gesamten Spulen 210a, 210b, 210c der Spulenanordnung 200 der FIG. 1, d.h. jeweils die Windungen 212a, 212b und 212c, 212d und 212e, 212f kombiniert, bestromt werden. In FIG. 3 ist der Stromfluss 85 durch die Spulen 210a, 210b, 210c als Funktion der Zeit aufgetragen. Ein solcher Stromfluss kann durch eine entsprechende Wechselspannung erreicht werden. Wie aus FIG. 3 ersichtlich, weisen die Wechselspannungen / der Stromfluss 85 eine Phasendifferenz von 120° auf - also entsprechend der Winkel 213a, 213b, 213c. Die Wechselspannung 85 kann z.B. durch einen Strom-Spannungs-Wandler, der die Spulenanordnung 200 mit einem 12 V Gleichspannungsnetz eines Kraftfahrzeugs verbindet, erzeugt werden. Die Wechselspannung 85 kann dann an die innersten und äußersten Kontakte eines mit der jeweiligen Spule 210a-210c assoziierten Arms angelegt werden.

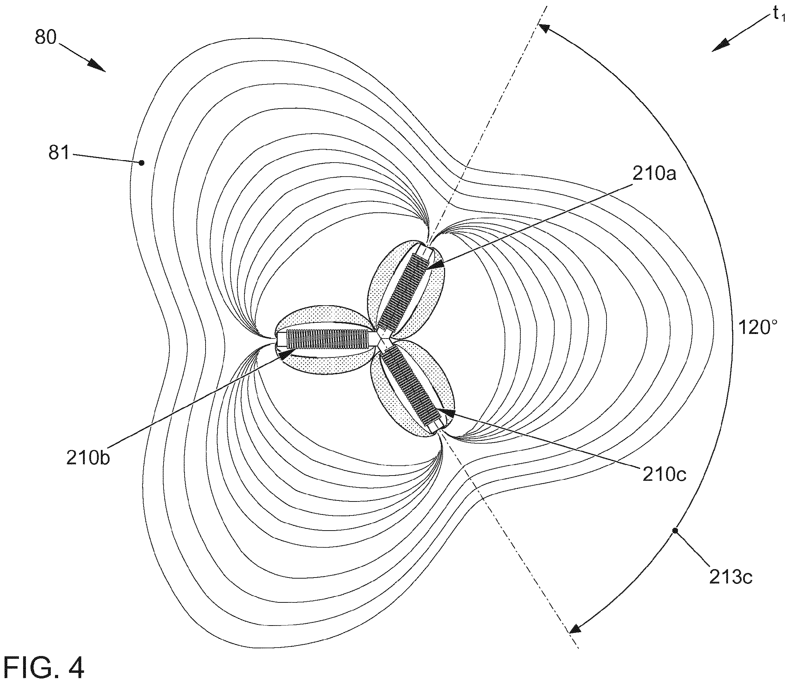

Eine solche Bestromung der Spulen 210a, 210b, 210c bewirkt ein elektromagnetisches Feld 80, wie es durch die in FIG. 4 aufgetragene Amplitude 81 der magnetischen Feldkomponente charakterisiert ist. FIG. 4 zeigt das em Feld 80 zum Zeitpunkt t₁.Das elektromagnetische Feld weist eine Symmetrie auf, die derjenigen der Spulenanordnung entspricht. Der Plot der FIG. 4 stellt das em Feld 80 insbesondere innerhalb der Spulenebene dar.

Es sollte verstanden werden, dass es möglich ist, ein elektromagnetisches Feld 80 gleich dem in FIG. 4 aufgetragenen auch mit anderen Konfigurationen der Spulenanordnung 200 zu erzeugen, die anders sind, als die in FIG. 1 dargestellte. Sind zum Beispiel die Winkel 213a-213c benachbarter Spulen 210a, 210b, 210c anders als die 120 der FIG. 1, so kann die Wechselspannung 85, insbesondere eine Phasenverschiebung, entsprechend angepasst werden (siehe FIG. 3). Dadurch kann die Änderung der benachbarten Winkel 213a, 213b, 213c kompensiert werden und eine Situation wie in FIG. 4 gezeigt aufrechterhalten werden. Entsprechendes gilt wenn, wie in FIG. 2 dargestellt, einzelne Spulen 210c aus der Spulenebene herausgekippt sind. Hierbei kann es möglich sein, die Projektion der entsprechenden Spule 210c in die Spulenebene zu berücksichtigen.

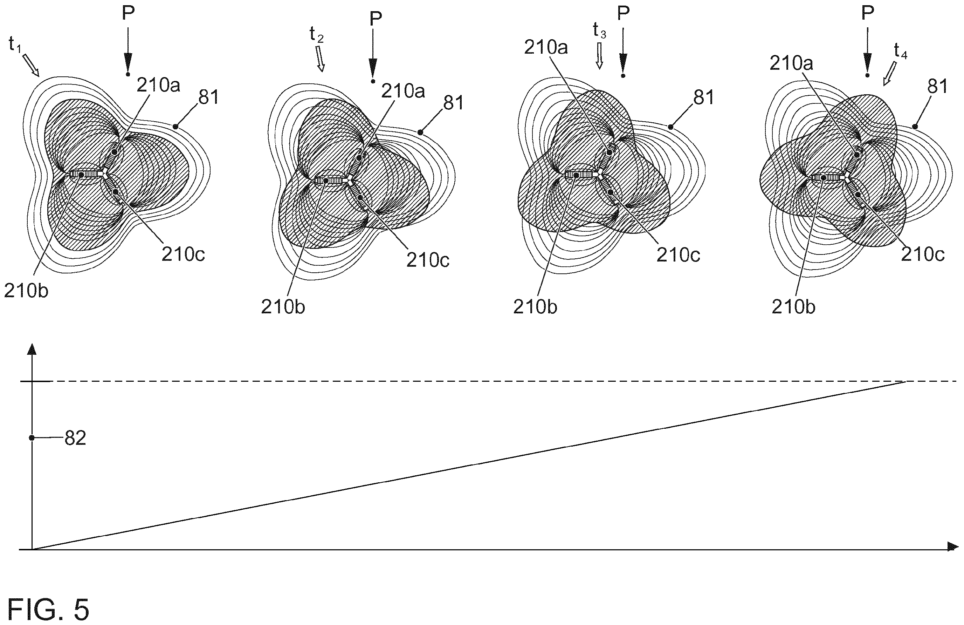

In Bezug auf die FIG. 5 wird nachfolgend die Rotation des em Felds 80 als Funktion der Zeit diskutiert, d.h. das rotierende em Feld 80 erläutert. Dargestellt ist das em Feld 80 zu vier verschiedenen Zeitpunkten t1, t2, t3, t4 (siehe auch FIG. 3). Untenstehend in FIG. 5 ist darüber hinaus die Phase 82 des rotierenden em Felds 80 aufgetragen. Eine Zunahme der Phase 82 für zunehmende Zeiten ist sichtbar (Phasenakkumulation). Wie aus FIG. 5 ersichtlich, rotiert das em Feld 80 innerhalb der Spulenebene um die Spulenanordnung 200. Die Spulenebene ist daher koinzident mit der Rotationsebene. Während in FIG. 5 eine Situation gezeigt ist, in der das em Feld 80 eine konstante Amplitude als Funktion des Winkels/der Phase aufweist, kann - z.B. in Abhängigkeit der Bauform der Spulenanordnung 200 - die Amplitude 81 des em Feldes 80 auch eine Abhängigkeit von der Phase aufweisen. Als bildliche Analogie zu der Betriebsweise der Spulenanordnung 200 zum Erzeugen des rotierenden em Felds 80 kann der Drehstrommotor gesehen werden.

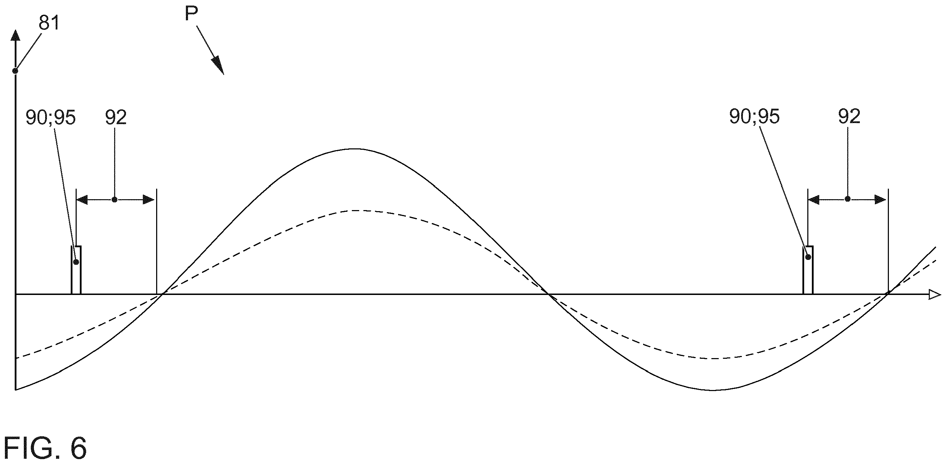

In FIG. 6 ist eine Messung der Amplitude 81 der magnetischen Feldkomponente des em Felds 80 an einem Punkt P (siehe auch FIG. 5) im Außenraum der Spulenanordnung 200 und innerhalb der Rotationsebene beispielhaft aufgetragen. In FIG. 6 ist weiterhin die Amplitude 81 für einen Punkt P' dargestellt (gestrichelte Linie) der gegenüber der Rotationsebene beabstandet ist und dessen Projektion in die Rotationsebene koinzident mit dem Punkt P ist. Die Differenz der Amplitude 81 zwischen den Punkten P und P' ist ein Maß für den Abstand des Punkts P' zur Rotationsebene. Die Amplitude 81 ist proportional zu einer Feldstärke des em Felds 80. Wie ersichtlich ist, variiert die Amplitude sinus-förmig (durchgezogene Linie). Es ist möglich, eine Differenzphase 92 gegenüber einer Referenzphase 90 zu bestimmen. Z.B. kann die Referenzphase 90 mit einer Taktinformation 95 durch Modulation des em Felds 80 übertragen werden.

Zur Modulation des em Felds 80 können Modulationstechniken zu verwenden, welche aus folgender Gruppe ausgewählt sind: Frequenzmodulation (FM), Phasenmodulation (PM), "Frequency Shift Keying" (FSK), "Phase Shift Keying" (PSK), Pulsamplitudenmodulation (PAM), Pulse-Code-Modulation (PCM). Im Allgemeinen sind weitere Modulationstechniken, wie sie dem Fachmann grundsätzlich bekannt sind, möglich. Es ist grundsätzlich auch möglich, die unterschiedlichen Komponenten des em Felds 80, die von den verschiedenen Spulen 201a, 210b, 210c erzeugt werden, mit einer unterschiedlichen Modulationstechnik und insbesondere Modulationsfrequenz zu modulieren.

Insbesondere kann auch die Taktinformation 95 durch separate Modulation der von den verschiedenen Spulen 201a, 210b, 210c ausgesendeten em Felder 80 übertragen werden. Dies kann in anderen Worten bedeuten, dass die Phase des em Felds 80 zeitaufgelöst übertragen werden kann. Dann kann es möglich sein, die Differenzphase 92 bereits aus dem Bruchteil einer ganzen Rotation des em Felds 80 zu bestimmen, etwa aus 1/3 oder 2/3 Rotation (im Fall von 3 Spulen mit Winkeln 213a, 213b, 213c von 120°).

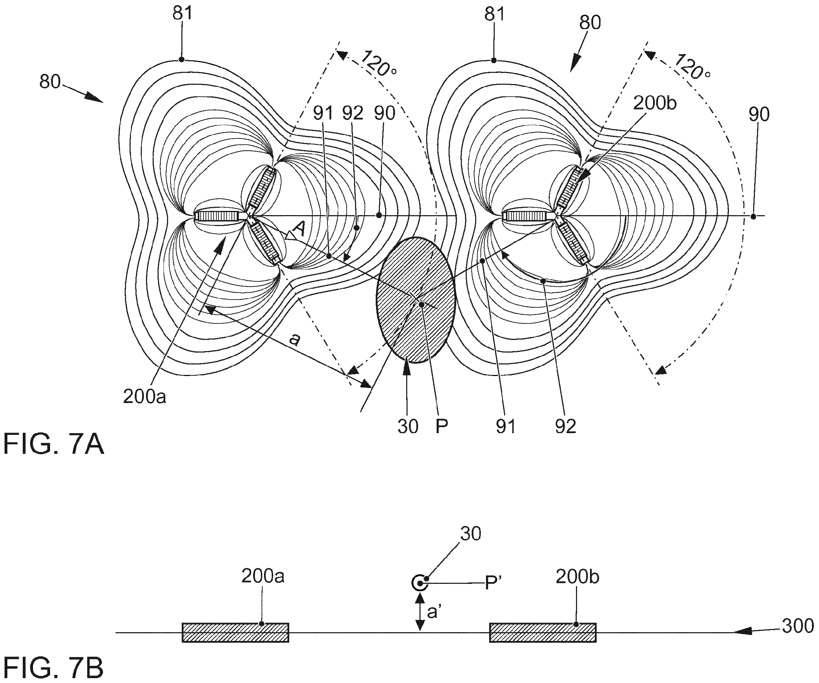

Es ist möglich, eine Position eines Empfängers durch den Betrieb der einzelnen Spulenanordnung 200 zu bestimmen. Position kann hierbei unterschiedliche Informationstiefen bezeichnen: insbesondere ist es z.B. möglich, die Position in Bezug auf einen Azimutwinkel in der Rotationsebene gegenüber der Spulenanordnung 200 aus der Differenzphase 92 zu bestimmen. Gemäß verschiedener Aspekte ist es aber auch möglich, die Position genauer zu bestimmen, indem zwei oder mehr Spulenanordnungen verwendet werden, siehe FIG. 7A. Genauer kann hierbei bedeuten, dass neben dem Azimutwinkel zusätzlich oder alternativ ein Abstand und / oder ein Polarwinkel bestimmt wird. In unterschiedliche Koordinatensysteme können die unterschiedlichen Koordinaten verschieden repräsentiert werden.

Es ist auch möglich, die Position nicht in einem Kugelkoordinatensystem (Abstand, Azimutwinkel, Polarwinkel) zu bestimmen, sondern in jedem beliebigen anderen Koordinatensystem. Die Position kann insbesondere in einem Referenzkoordinatensystem bestimmt werden. Das Referenzkoordinatensystem kann zweckmäßigerweise in Bezug auf die Positionen der Spulenanordnung(en) 200 bestimmt sein oder aber z.B. in Bezug auf ein Kraftfahrzeug, indem die Spulenanordnung(en) 200 verbaut sind.

In FIG. 7A werden zwei Spulenanordnungen 200a, 200b zur Bestimmung der Position P eines Empfänger 30, z.B. eines Identifikationsgebers wie einem Schlüssel eines Kraftfahrzeugs, verwendet z.B. im Rahmen eines entsprechenden Ortungssystems. Der Empfänger 30 ist eingerichtet, um das rotierende em Feld 80 der beiden Spulenanordnungen 200a, 200b zu messen. Dazu kann der Empfänger z.B. eine oder mehrere Empfängerspulen (in FIG. 7A nicht gezeigt) aufweisen. Der Empfänger ist weiterhin eingerichtet, um daraus die Differenzphase 92 zu ermitteln. Wie aus FIG. 7A ersichtlich, weist der Empfänger 30 unterschiedliche Differenzphasen 91 gegenüber den em Feldern 80 der beiden Spulenanordnungen 200a, 200b auf. Sind beide Differenzphasen 92 bestimmt und ist der Abstand zwischen den Spulenanordnungen 200a, 200b bekannt, kann z.B. mittels Triangulierung die genaue Position des Empfängers 30 innerhalb der Rotationsebene der em Felder 80 bestimmt werden. Die Position kann durch die Richtung A und die Entfernung a z.B. gegenüber der Spulenanordnung 200a charakterisiert sein.

Es ist möglich, eine noch größere Genauigkeit in der Bestimmung der Position P des Empfängers 30 zu erreichen: Dies kann dadurch geschehen, dass zusätzlich zu den Differenzphasen 92 auch eine Feldstärke des elektromagnetischen Felds 80 oder eine dazu proportionale Größe durch den Empfänger gemessen wird. Durch zusätzliche Messung der Feldstärke, d.h. zum Beispiel der Amplitude der magnetischen Komponente des elektromagnetischen Felds, kann es nämlich möglich sein, einen vertikalen Abstand a' des Empfängers 30 gegenüber der Rotationsebene zu bestimmen. Dies ist in FIG. 7B (Seitenansicht der FIG. 7A) durch den vertikalen Pfeil illustriert. Befindet sich der Empfänger 30 nämlich an einer Position P' oberhalb oder unterhalb der Rotationsebene 300 der rotierende elektromagnetischen Felder 80, so kann durch die obenstehend beschriebene Triangulierung basierend auf den Differenzphasen 92 eine Projektion der Position des Empfängers 30 in die Rotationsebene 300 eindeutig bestimmt werden. Abhängig von der vertikalen Beabstandung des Empfängers 30 gegenüber der Rotationsebene 300, kann dann die Feldstärke des em Felds 80 größer oder kleiner sein (siehe gestrichelte Linie in FIG. 6).

Werden neben den beiden Spulenanordnungen 200a, 200b noch weitere Spulenanordnungen verwendet, so kann eine Unsicherheit in der Positionsbestimmung reduziert werden z.B. kann ein Fehler der Triangulation bestimmt werden. Während voranstehend in Bezug auf die FIG. 7A und 7B Techniken zur Bestimmung der Position des Empfängers 30 in Bezug auf zwei Spulenanordnungen 200a, 200b diskutiert wurden, so sollte verstanden werden, dass es im Allgemeinen möglich ist, mehr als zwei Spulenanordnungen 200a, 200b zu verwenden. Werden zum Beispiel drei, vier oder fünf Spulenanordnung verwendet, so kann es möglich sein, einen Fehler in der Bestimmung der Position des Empfängers 30 zu reduzieren. Die mehreren em Felder 80 können sequentiell bzw. nacheinander zu verschiedenen Zeitpunkten ausgesendet werden (Zeit-Multiplexen) oder zumindest teilweise zeitgleich mit unterschiedlichen Frequenzen (Frequenz-Multiplexen). Dadurch kann der Empfänger 30 das jeweils gemessene em Feld 80 einer der Spulenanordnungen 200a, 200b zuordnen.

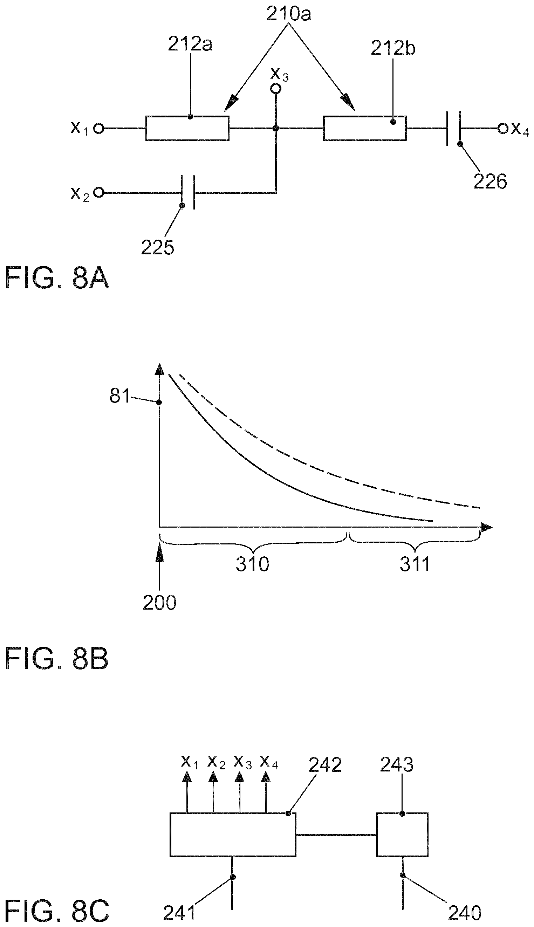

In FIG. 8A ist eine elektrische Verschaltung der Spule 210a dargestellt. Sichtbar sind insbesondere die zwei Spulenwicklungen 212a, 212b. Die beiden Spulenwicklungen 212a, 212b können gekoppelt durch Kontaktieren an den Kontakten x1 und x4 betrieben werden (siehe auch FIG. 1). Ein Kondensator 226 ist mit den zwei Spulenwicklungen 212a, 212b in Reihe geschaltet. Es ist jedoch auch möglich, die Spulenwicklungen 212a alleine zu betreiben. Dazu ist ein weiterer Kondensator 225 in Parallelschaltung mit der Spulenwicklung 212a vorgesehen.

Eine Induktivität der Spule 210a ist in dem Fall, dass die Spulenwicklungen 212a, 212b gekoppelt betrieben werden, größer als in dem Fall, dass lediglich die Spulenwicklung 212a betrieben wird. Daher kann insbesondere eine Resonanzfrequenz für den erstgenannten Fall geringer sein als eine Resonanzfrequenz für den letztgenannten Fall. Zum Beispiel kann die Resonanzfrequenz bei einem Betrieb der Spule 210a mit den beiden Spulenwicklungen 212a, 212b durch geeignete Dimensionierung der Induktivitäten sowie der Kapazität des Kondensators 226 derart gewählt werden, dass sie 125 kHz beträgt. Entsprechend kann eine Resonanzfrequenz für einen Betrieb der Spule 210a, der lediglich die Spulenwicklung 212a und den weiteren Kondensator 225 umfasst, gleich 1 MHz gewählt werden. Es ist natürlich möglich, andere Frequenzen durch geeignete Dimensionierung der Kapazitäten und Induktivitäten zu erzeugen. Dem Fachmann sind hierzu vielfache Techniken bekannt.

Im Allgemeinen kann eine Leistungsaufnahme bei Aussenden des em Felds für die Reihenschaltung mit Kondensator 226 größer sein, als für die Parallelschaltung mit dem weiteren Kondensator 225. Bei bestimmten Anwendungen, etwa zur Umfeldsuche eines Empfängers im Fernbereich. Die Ansteuerung der Parallelschaltung mit dem weiteren Kondensator 224 bei vorzugsweise 1 MHz kann z.B. ein nicht rotierendes em Feld beinhalten. Ein solches Szenario ist durch die geringe elektrische Leistungsaufnahme gekennzeichnet, was z.B. für eine Annäherungserkennung im weiten Umfeld, d.h. für große Reichweiten bis zu 10 m vom Kraftfahrzeug 1, zu bevorzugen sein kann. Wenn der Identifikationsgeber 30 in diesem fernen Umfeld erkannt wird, dann kann die Reihenschaltung mit dem Kondensator 226 aktiviert werden. In diesem Betriebsmodus kann die Position und der Positionsverlauf des Identifikationsgebers 30 im Nahbereich, z.B. bis zu 3 m vom Kraftfahrzeug 1, bestimmt werden. Ein derartiges hierarchisches Betreiben kann einen geringeren Energieverbrauch bewirken, was insbesondere bei Elektrofahrzeugen erstrebenswert sein kann.

In einem Frequenzbereich, welcher die oben genannten Frequenzen beinhaltet, kann eine Abklingrate des elektromagnetischen Felds 80 abhängig von der Frequenz sein. So können höhere Frequenzen eine geringere Abklingrate des elektromagnetischen Felds 80 bewirken. Dies ist in der FIG. 8B dargestellt. In der FIG. 8B ist die Amplitude 81 etwa der magnetischen Komponente des elektromagnetischen Felds 80, über dem Ort als Abstand gegenüber der aussendenden Spulenanordnung 200 aufgetragen. Die durchgezogene (gestrichelte) Linie illustriert den Fall einer vergleichsweise niedrigen (großen) Resonanzfrequenz des entsprechenden Schwingkreises, wie obenstehend in Bezug auf FIG. 8A diskutiert. Wie aus FIG. 8B ersichtlich, ist eine Abklingrate des elektromagnetischen Felds 80 für höhere Resonanzfrequenzen geringer. Deshalb kann es möglich sein, durch Bestromen nur einer (beider) Spulenwicklung 212a (212a, 212b) eine Bestimmung der Position des Empfängers 30 in einem Fernbereich 311 (Nahbereich 310) der Spulenanordnung 200 durchzuführen.

In FIG. 8C ist eine mit einer Versorgungsleitung 241 verbundene Wechselspannungs-Quelle 242 schematisch dargestellt. Die Versorgungsleitung 241 kann z.B. ein 12 V Gleichspannungsnetz eines Kraftfahrzeugs sein. Die Wechselspannungs-Quelle 241 ist eingerichtet, um eine Wechselspannung wie in FIG. 3 gezeigt, zu erzeugen. In FIG. 8C ist weiterhin eine Rechnereinheit 243 dargestellt, die eingerichtet ist, Steuersignale über ein Bussystem 240 zu empfangen und basierend darauf das Aussenden des em Feldes 80 zu steuern.

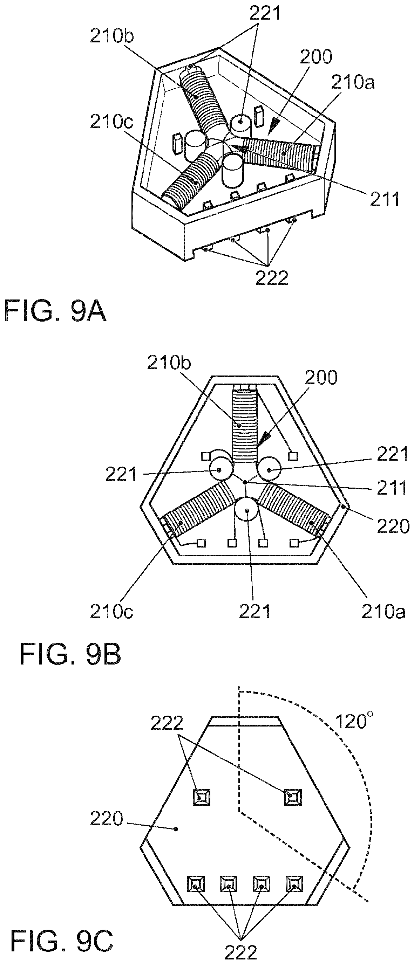

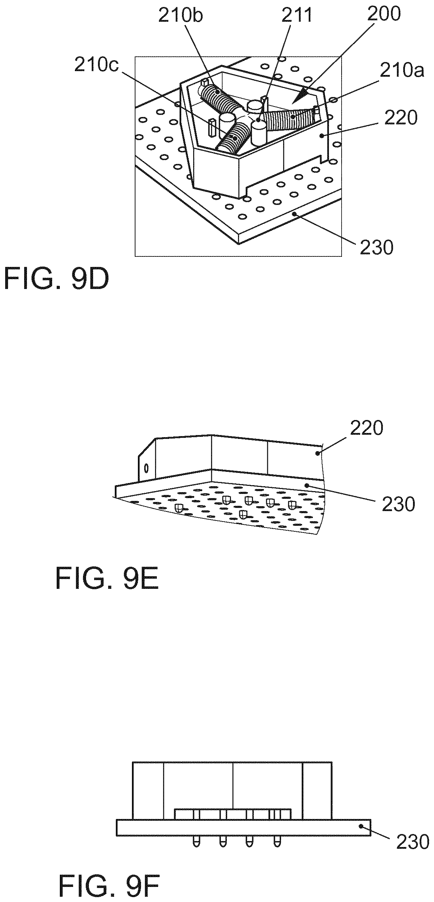

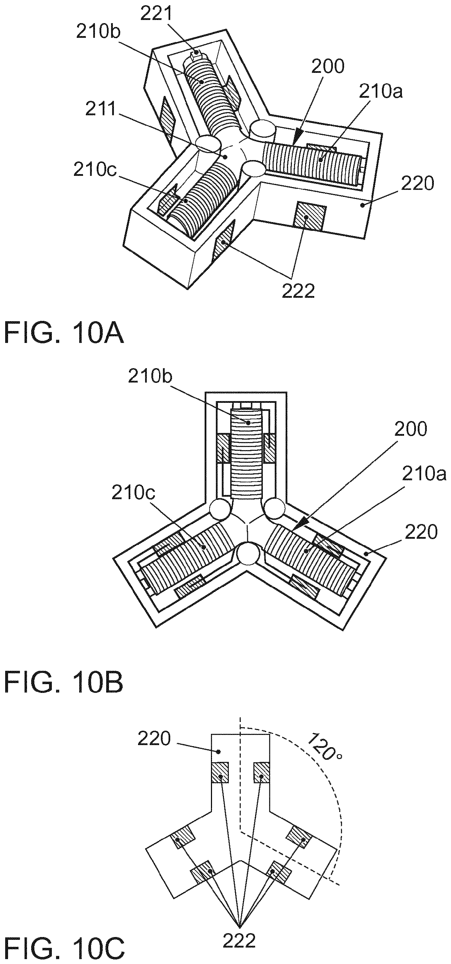

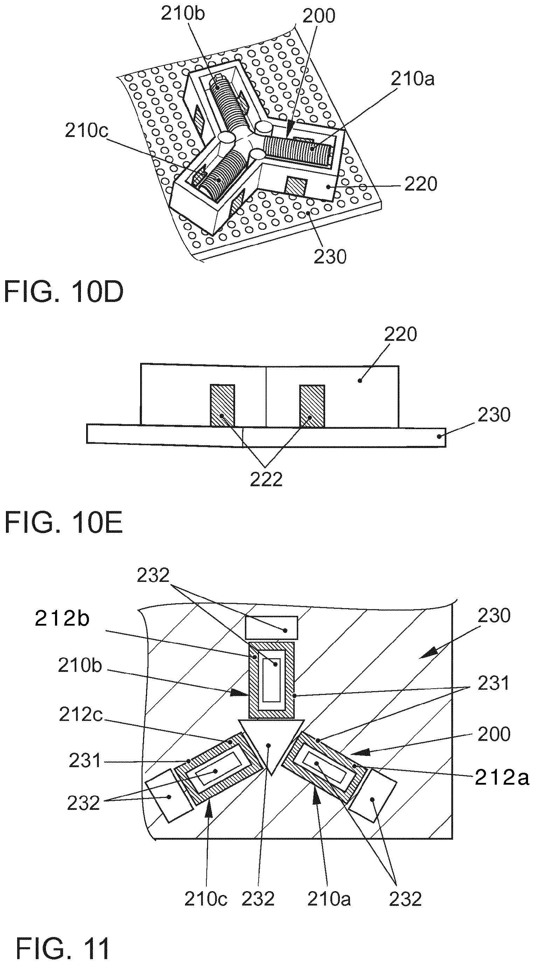

In den FIGs. 9A-9F, sowie 10A-10D sind verschiedene Ansichten der Spulenanordnung 200 aus FIG. 1 in einem Gehäuse 220 dargestellt. Die Kondensatoren 225, 226 und weitere Leistungselektronik können auch innerhalb des Gehäuse angeordnet werden. Es sind elektrische Kontakte 222 dargestellt, welche die Spulenanordnung mit Leiterbahnen auf einer Leiterplatte 230 verbinden können. Z.B. können die Kontakte mit der Wechselspannungs-Quelle 242 über Leiterbahnen auf der Leiterplatte verbunden sein. Darüber hinaus sind Halter 221 vorgesehen, welche die Spulenanordnung 200 ortsfest innerhalb des Gehäuses 220 fixieren. Das Gehäuse kann Schutz gegen Erschütterungen, Ablagerungen, Feuchtigkeit usf. darstellen und kann vorzugsweise aus Kunststoff gefertigt sein. Eine Oberseite des Gehäuses 220 ist aus Gründen der Übersichtlichkeit nicht dargestellt, kann aber vorgesehen sein. Wie aus den FIGs. 9A-9F, sowie 10A-10D ersichtlich, kann eine Ober- und Unterseite des Gehäuses, sowie die Leiterplatte 230 parallel zu der Rotationsebene 300 bzw. der Spulenebene sein. Die spezielle Gehäuseform ist nicht limitierend und kann verschieden gewählt werden. Es sollte verstanden werden, dass je nach Bauraum der zur Verfügung steht, unterschiedliche Gehäuse 220 bevorzugt werden können. Das Gehäuse kann parallel zum Boden ausgerichtet angebracht sein.

In der FIG. 11 ist eine erfindungsgemässe Ausführungsform der Spulenanordnung 200 dargestellt. Diese Ausführungsform entspricht einer integrierten Bauform, bei der Leiterbahnen 231 die Spulenwicklungen 212a, 212c, 212e planar auf einer Leiterplatte 230 (gestrichelt) ausbilden. Die Leiterbahnen können z.B. durch Ätz- oder Masken- oder Lithographie-Techniken hergestellt werden.

Es sind Aussparungen 232 der Leiterplatte 230 vorgesehen, in die das Spulenjoch 211 (in FIG. 11 nicht gezeigt) eingeführt und fixiert werden kann. Diese Ausführungsform kann den Effekt eines besonders geringen Platzbedarfs aufweisen.

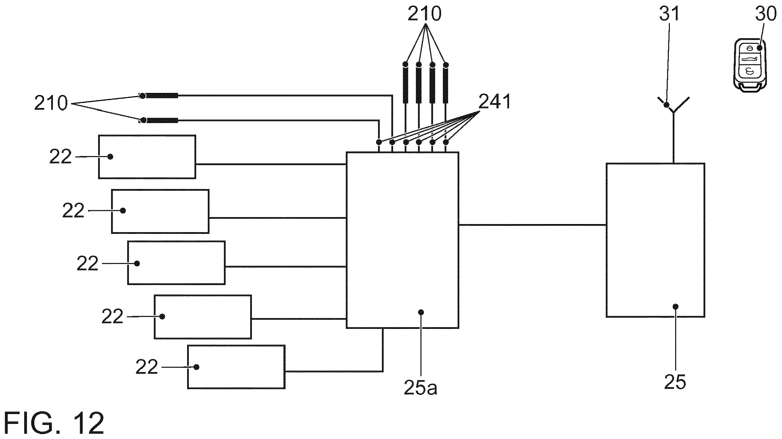

Nachfolgend wird anhand der FIGs. 12 - 14 eine Systemarchitektur eines Ortungssystems 100 erläutert, welches mindestens zwei Spulenanordnungen 200, 200a, 200b umfasst. Durch Techniken, wie sie in Bezug auf die FIGs. 7A und 7B voranstehend beschrieben wurden, kann das Ortungssystem 100 eine Position des Empfängers 30, etwa eines Schlüssels zu einem Kraftfahrzeug genau bestimmen. Die Ortsbestimmung kann sowohl im Außenraum als auch im Innenraum des Kraftfahrzeugs vergleichsweise genau, z.B. bis auf wenige Zentimeter genau, erfolgen. Z.B. kann die bestimmte Position des Schlüssels dem Benutzer graphisch dargestellt werden, etwa auf einem Bildschirm eines Bordcomputers des Kraftfahrzeugs 1. Dazu können rotierende em Felder erzeugt werden.

In FIG. 12 ist zunächst ein vorbekanntes Ortungssystem 100 dargestellt. Ein Steuergerät 25 ist mit einem weiteren Steuergerät 25a verbunden. Zum Beispiel kann das Steuergerät 25 Teile einer zentralen Rechnereinheit des Kraftfahrzeugs sein. Darüber hinaus ist das Steuergerät 25 mit einer Funkschnittstelle 31 verbunden, welche Datenübertragung mit dem Identifikationsgeber 30 herstellen kann. Das weitere Steuergerät 25A ist über Datenleitungen mit Türgriffsensoren 22 des Kraftfahrzeugs verbunden. Diese Türgriffsensoren 22 können eine Betätigung oder Zugangswunsch der Schließklappen des Kraftfahrzeugs, wie etwa Türen und Heckklappen, detektieren. Darüber hinaus ist das weitere Steuergerät 25a über Versorgungsleitungen 241 mit einzelnen Spulen 210 zur Erzeugung von elektromagnetischen Feldern, die von dem Identifikationsgeber 30 gemessen werden können, verbunden. Wie aus FIG. 12 ersichtlich, ist die Systemarchitektur des vorbekannten Ortungssystems vergleichsweise aufwändig gestaltet. Insbesondere müssen die zum Beispiel zweiadrigen Versorgungsleitungen 241 in einer großen Zahl vorgehalten werden, was eine komplizierte Verkabelung des Kraftfahrzeugs notwendig macht: das Steuergerät 25a umfasst eine Wechselspannungs-Quelle, die die Spulen 210 über die Leitung 241a mit Spannung versorgt.

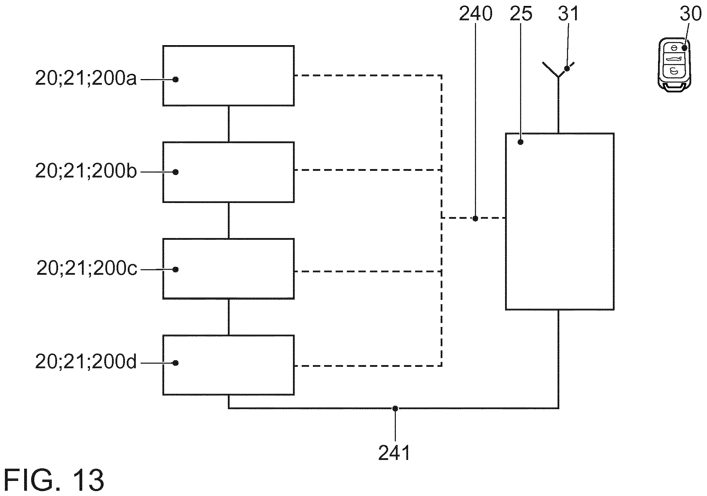

In FIG. 13 ist das erfindungsgemäße Ortungssystem 100 schematisch dargestellt.

Vier Spulenanordnungen 200a-200d, sowie kapazitive Sensoren 20 und optische Sensoren 21 sind vorgesehen. Die Spulenanordnungen 200a-200d können über eine Rechnereinheit (in FIG. 13 nicht gezeigt) mit einem Bussystem 240 verbunden sein, das Datenkommunikation mit dem Steuergerät 25 ermöglicht. Das Bussystem kann z.B. ein "Controller Area Network" (CAN) Bussystem, "Local Interconnect Network" (LIN), oder "FlexRay" oder ein anderes Bussystem sein. Das Steuergerät 25 kann Befehle über das Bussystem 240 senden, welche von der Rechnereinheit der jeweiligen Spulenanordnung 200a-200d empfangen und interpretiert werden. Dann sind die Spulenanordnungen 200a-200d eingerichtet, um als Reaktion auf die Steuersignale, jeweils ein rotierendes em Feld 80 zu erzeugen. Die dazu erforderliche Energie kann aus der Versorgungsleitung 241 erhalten werden. Z.B. kann die Versorgungsleitung Gleichspannung (etwa 12 V) zur Verfügung stellen, so dass ein entsprechender elektrischer Schaltkreis, also eine Wechselspannungs-Quelle, in den Spulenanordnungen 200a-200d eingerichtet ist, um die zur Erzeugung des em Feldes 80 erforderlichen Wechselspannungen mit vorgegebener Phasenbeziehung daraus zu erzeugen. Z.B. kann die Steuereinheit 25 die Spulenanordnungen 200a-200d so ansteuern, dass die jeweiligen em Felder 80 zu verschiedenen Zeiten (Zeit-Multiplexen) und / oder mit verschiedenen Frequenzen (Frequenz-Multiplexen) ausgesendet werden. Mit den Techniken, wie sie in Bezug auf die FIGs. 7A und 7B beschrieben wurden, kann dann eine Position des Empfängers 30 bestimmt werden. Das Ortungssystem 100 der FIG. 13 kann im Vergleich zu dem System der FIG. 12 eine schnellere Reaktionszeit aufweisen, da das zwischengeschaltete Steuergerät 25a entfällt.

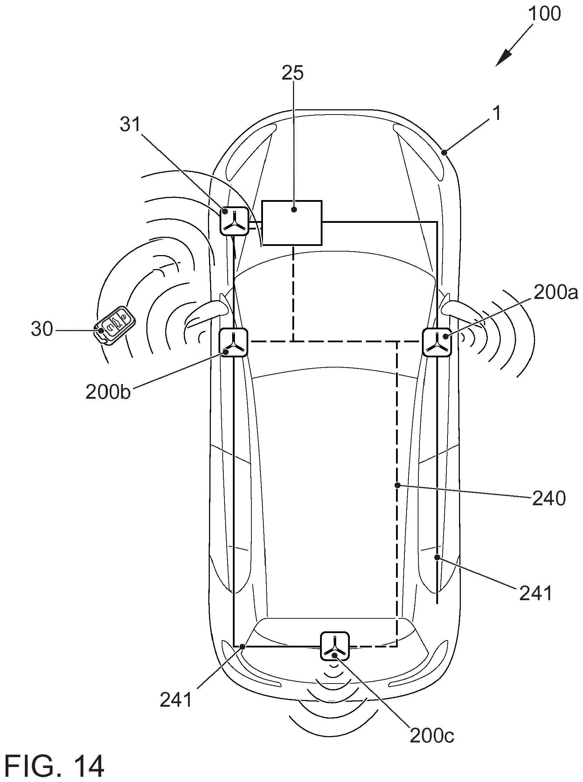

FIG. 14 zeigt das Ortungssystem 100 mit einer Anordnung in dem Kraftfahrzeug 1. Aus FIG. 14 ist wiederum ersichtlich, dass eine Steuerung und eine Energieversorgung über die getrennten Leitungen 240, 241 erfolgt. In der FIG. 14 sind die Spulenanordnungen 200a, 200b in den rechten und linken Vordertüren verbaut. Es wäre auch möglich, die Spulenanordnungen 200a, 200b in den links- und rechtsseitigen B-Säulen und/oder C-Säulen zu verbauen. Es könnten modular weitere Spulenanordnungen vorgesehen werden, etwa im Bereich des Kraftfahrzeug-Hecks.

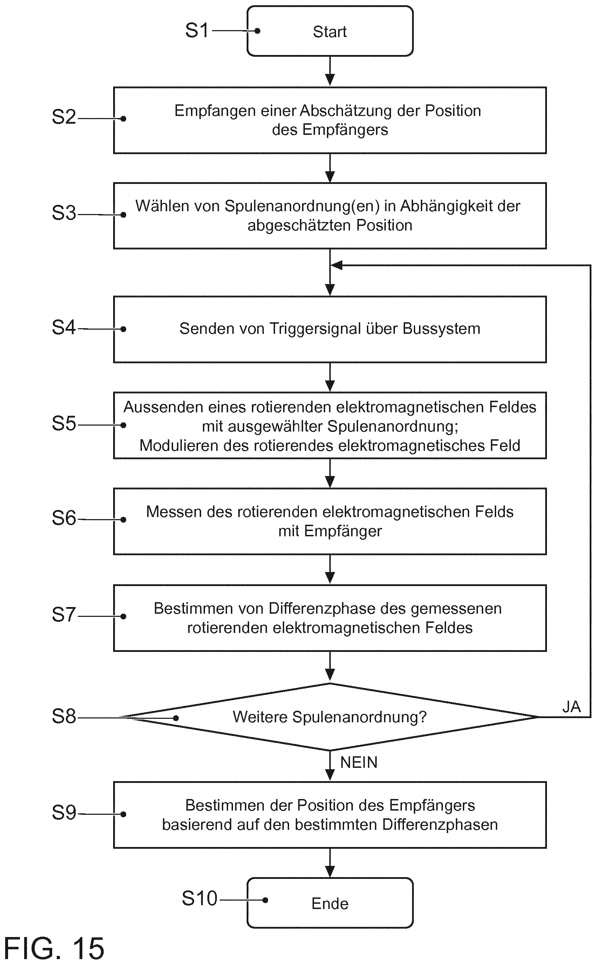

In FIG. 15 ist ein Flussdiagramm eines Verfahrens zur Bestimmung einer Position eines Empfängers dargestellt. Das Verfahren beginnt mit Schritt S1. Z.B. kann der Beginn des Verfahrens durch ein externes Triggersignal ausgelöst werden - ein solches Triggersignal kann z.B. die Betätigung eines Türgriffs sein oder eine Annäherungserkennung. Zunächst erfolgt in Schritt S2 das Empfangen einer Abschätzung der Position des Empfängers 30. Zum Beispiel kann eine Abschätzung der Position des Empfängers 30 über die optischen und/oder kapazitiven Sensoren 20, 21, welche in den Türgriffen des Kraftfahrzeugs 1 vorgehalten werden (siehe auch FIG. 13) erfolgen. Die Abschätzung der Position des Empfängers 30 kann daher zum Beispiel eine Informationstiefe enthalten, wie: "Empfänger 30 befindet sich vorne links gegenüber dem Kraftfahrzeug 1" oder "Empfänger 30 befindet sich hinter dem Kraftfahrzeug 1".

Anschließend erfolgt in Schritt S3 die Auswahl der Spulenanordnung oder der Spulenanordnungen, die nachfolgend das rotierende em Feld 80 aussenden sollen, in Abhängigkeit der abgeschätzten Position in Schritt S2. Ist zum Beispiel aus Schritt S2 bekannt, dass sich der Empfänger 30, wie in FIG. 14 dargestellt, links vorne neben dem Kraftfahrzeug 1 befindet, so können zum Beispiel die Spulenanordnungen 200b und 200c ausgewählt werden - dies ist der Fall, da zu einer Triangulierung basierend auf Differenzphasen (wie voranstehend in Bezug auf die FIG. 7A und 7B beschrieben) der Informationsgewinn durch die Bestimmung der Differenzphase mittels der Spulenanordnung 200a aufgrund des geringen Winkelunterschieds zum Empfänger 30 gegenüber der Spulenanordnung 200b gering ist. Es wäre alternativ zum Beispiel auch möglich, alle drei Spulenanordnungen 200a-200c oder lediglich die Spulenanordnung 200b etc. zu betreiben. In Schritt S4 wird ein Triggersignal über das Bussystem zu einer der in Schritt S3 ausgewählten Spulenanordnungen 200a-200c gesendet. Diese aktuelle Spulenanordnung sendet dann das rotierende elektromagische Feld 80. Das rotierende elektromagnetische Feld 80 wird durch die entsprechende Spulenanordnung 200a-200c derart erzeugt, dass es durch Modulation sowohl Informationen zur Identifikation des Kraftfahrzeugs 1 als auch Taktinformation 95 beinhaltet. Z.B. kann die Taktinformation eine Referenzphase beinhalten, gegenüber der die Differenzphasen bestimmt werden. Es wäre auch möglich, die Differenzphasen gegenüber dem externen Triggersignal aus Schritt S1 zu bestimmen. Das Aussenden des rotierenden elektromagnetischen Felds 80 kann mittels Anlegen mehrerer phasenverschobener Wechselspannungen 85 an die verschiedenen Spulen 210a-210c der jeweiligen Spulenanordnung 200a-200c und Überlagerung der entsprechenden em Felder geschehen.

In Schritt S6 erfolgt das Messen des elektromagnetischen Felds 80. Daher können die Schritte S5 und S6 zum Beispiel zeitgleich durchgeführt werden. Das Messen in Schritt S6 kann z.B. das zeit-/frequenzaufgelöste induktive Messen der Amplitude 81 der magnetischen Feldkomponente umfassen. In Schritt S7 erfolgt das Bestimmen der Differenzphase 92 des gemessenen elektromagnetischen Felds 80. Zum Beispiel kann Schritt S7 auf einer Rechnereinheit innerhalb des Empfängers 30 durchgeführt werden. Es ist aber auch möglich, die Informationen des gemessenen rotierenden elektromagnetischen Felds 80 aus Schritt S6 über die Funkschnittstelle 31 an die Steuereinheit 25 zu übertragen, so dass diese Schritt S7 durchführen kann. In Schritt S8 wird überprüft, ob das Aussenden und Messen eines weiteren elektromagnetischen Felds 80 durch eine weitere Spulenanordnung 200a-200c benötigt wird. Ist dies der Fall, werden die Schritte S4-S7 erneut durchgeführt. Andernfalls erfolgt in Schritt S9 das Bestimmen der Position des Empfängers basierend auf den bestimmten Differenzphasen 92. Schritt S9 kann zum Beispiel eine Triangulierung beinhalten. Schritt S9 kann zum Beispiel auf einer Rechnereinheit innerhalb des Steuergeräts 25 oder in dem Empfänger 30 durchgeführt werden. Das Verfahren endet in Schritt S10.

Während voranstehend ein Technik erläutert wurde, in der separate Triggersignale in Schritt S4 zur Ansteuerung der verschiedenen Spulenanordnungen 200a-200c verwendet werden, wäre es auch möglich, den Schritt S4 lediglich einmal durchzuführen und bereits in dem einmal ausgesendeten Triggersignal alle Informationen darüber zu beinhalten, welche Spulenanordnung 200a-200c das elektromagnetische Feld 80 erzeugen soll. In einem solchen Fall könnte das Triggersignal Zeitgeber in den jeweiligen Spulenanordnungen 200a-200c initiieren; die Zeitgeber wären so konfiguriert, dass die verschiedenen Spulenanordnungen 200a-200c zu unterschiedlichen Zeitpunkten das elektromagnetische Feld 80 aussenden.

Darüber hinaus wäre es möglich, neben dem oben stehend beschriebenen Zeit-Multiplexen auch Techniken des Frequenz-Multiplexens durchzuführen und die verschiedenen em Felder 80 zumindest teilweise zeitgleich auszusenden.

Darüber hinaus sollte verstanden werden, dass Schritt S9 eine unterschiedliche Genauigkeit des Bestimmens der Position P, P' des Empfängers 30 bezeichnen kann: Zum Beispiel kann es möglich sein, wenn lediglich ein rotierendes elektromagnetisches Feld 80 ausgesendet und gemessen wird (Schritte S5 und S6), dass lediglich die Position P, P' des Empfängers als ein Winkel bzw. Richtung A gegenüber der entsprechenden Spulenanordnung 200a-200c bestimmt wird. Werden jedoch zwei oder mehr rotierende elektromagnetische Felder 80 verwendet, so kann die Position P, P' des Empfängers genau innerhalb der Rotationsebene 300 der elektromagnetischen Felder 80 bestimmt werden: Dies kann insbesondere den Abstand a zu einer Spulenanordnung 200a-200c beinhalten. Optional wäre es in Schritt S6 möglich, die Feldstärke des rotierenden elektromagnetischen Felds 80, d.h. zum Beispiel die Amplitude 81 der magnetischen Komponente des elektromagnetischen Felds 80, zu messen und daraus auf einen Abstand a' der Position P' des Empfängers 30 zu der Rotationsebene in Schritt S9 zu schließen (siehe gestrichelte Linie in FIG. 6). Insbesondere kann hierzu z.B. eine Ausführungsform der Spulenanordnung 200 verwendet werden, bei der einzelne oder mehrere Spulen 210a, 210b, 210c gegenüber der Spulenebene verkippt sind; ein solcher Fall ist z.B. in der FIG. 2 illustriert. Es können auch mehrere Spulenanordnungen verwendet werden, die gegeneinander verkippt sind. Solche Konfigurationen können den Vorteil aufweisen, dass für Positionen welche gleiche Abstände gegenüber der Rotationsebene aufweisen, jedoch oberhalb bzw. unterhalb angeordnet sind (d.h. spiegelsymmetrisch in Bezug auf die Rotationsebene), unterschiedliche Feldstärkewerte gemessen werden. Derart kann bestimmt werden, ob sich der Empfänger 30 ober- oder unterhalb der Rotationsebene befindet. Obwohl die Erfindung im Detail durch die bevorzugten Ausführungsformen unter Bezugnahme auf die Figuren näher illustriert und beschrieben wurde, so ist die Erfindung nicht durch die offenbarten Beispiele eingeschränkt und andere Variationen können vom Fachmann hieraus abgeleitet werden, im Rahmen des in den Ansprüchen definierten Schutzumfangs der Erfindung. Z.B. ist es möglich, obenstehend beschriebene Techniken, welche Anwendung in der Positionsbestimmung für einen Schlüssel eines Kraftfahrzeugs dienen, für Personenortungssysteme anzuwenden. Typische Anwendungsfälle wären z.B. das Orten von Personen und Gegenständen, welche einen Empfänger zur Auswertung der Phaseninformationen mit sich tragen. Für den Sender sind alle Funktechniken, z.B. Bluetooth ©, Wireless-LAN (WLAN), Radio Frequency Identification (RFID) und weitere möglich.

Zum Beispiel wäre es darüber hinaus möglich, das Ortungssystem 100 für verschiedene Anwendungsfälle einzusetzen, welche auf der besonders genauen Positionsbestimmung beruhen. So wäre es z.B. möglich, durch das genaue Bestimmen der Position des Schlüssels 30 eine Steuerung des Kraftfahrzeugs 1 durch Bewegungserkennung des Schlüssels 30 zu ermöglichen. Eine links-rechts-Bewegung des Schlüssels 30 könnte so z.B. eine links-rechts-Drehung des Kraftfahrzeugs 1 bewirken. Der Benutzer könnte sich außerhalb des Kraftfahrzeugs 1 befinden und dieses fernsteuern.

## Patentansprüche

1. Spulenanordnung (200) zum Erzeugen eines rotierenden elektromagnetischen Felds (80), wobei die Spulenanordnung (200) umfasst:
- mindestens drei Spulen (210a, 210b, 210c), jeweils mit mindestens einer zugehörigen Spulenwicklung (212a-212c),
- ein ferromagnetisches Spulenjoch (211), welches eine magnetische Kopplung der mindestens drei Spulen (210a, 210b, 210c) herstellt,
**dadurch gekennzeichnet, dass**
jede der Spulenwicklungen (212a-212c) als Windungen ausbildende planare Leiterbahn (231) auf einer Leiterplatte (230) ausgestaltet ist,
die Leiterplatte (230) Aussparungen (232) für das ferromagnetische Spulenjoch (211) aufweist und
das ferromagnetische Spulenjoch (211) oberhalb und unterhalb der Leiterplatte (230) angeordnet ist.

2. Spulenanordnung (200) nach Anspruch 1,
**dadurch gekennzeichnet,**
**dass** die mindestens drei Spulen (210a, 210b, 210c) in einer Spulenebene angeordnet sind und
**dass** benachbarte Spulen (210a, 210b, 210c) innerhalb der Spulenebene unter Winkeln (213a, 213b, 213c) von 120° angeordnet sind.

3. Spulenanordnung (200) nach Anspruch 1,
**dadurch gekennzeichnet,**
**dass** eine dritte Spule (210c) der mindestens drei Spulen (210a, 210b, 210c) einen Winkel (β) mit einer von einer ersten und zweiten Spule (210a, 210b) der mindestens drei Spulen (210a, 210b, 210c) aufgespannten Spulenebene einschließt.

4. Ortungssystem (100) zum Bestimmen einer Position (P, P') eines Identifikationsgebers (30) für ein Kraftfahrzeug (1), das Ortungssystem (100) umfassend:
- mindestens zwei Spulenanordnungen (200) gemäß einem der Ansprüche 1 - 3, wobei die mindestens zwei Spulenanordnungen (200) an unterschiedlichen Orten des Kraftfahrzeugs ortsfest montierbar sind und eingerichtet sind, um jeweils als Sender für ein rotierendes elektromagnetisches Feld (80) betrieben zu werden,
- den Identifikationsgeber (30) mit einer Empfangsspule, wobei der Identifikationsgeber (30) eingerichtet ist, um als Empfänger für die mindestens zwei rotierenden elektromagnetischen Felder (30) betrieben zu werden.

5. Kraftfahrzeug umfassend ein Ortungssystem (100) nach Anspruch 4,
**dadurch gekennzeichnet, dass** das Ortungssystem weiterhin umfasst:
- ein Steuergerät (25), welches eingerichtet ist, um die mindestens zwei Spulenanordnungen (200) zum Aussenden des jeweiligen rotierenden elektromagnetischen Felds (80) in einer vorgegebenen Abfolge anzusteuern.

6. Kraftfahrzeug nach Anspruch 5,
**dadurch gekennzeichnet,**
**dass** das Steuergerät (25) über ein Bussystem (240) des Kraftfahrzeugs mit den mindestens zwei Spulenanordnungen (200) gekoppelt ist,
**dass** jede der mindestens zwei Spulenanordnungen (200) mit einer Versorgungsleitung (241) im Kraftfahrzeug gekoppelt ist, und
**dass** jede der mindestens zwei Spulenanordnungen (200) eingerichtet ist, um ein Steuersignal des Steuergeräts über das Bussystem (240) zu empfangen und in Abhängigkeit des Steuersignals das rotierende elektromagnetische Feld (80) zu erzeugen, wobei die Energie zum Aussenden des rotierenden elektromagnetischen Felds (80) über die Versorgungsleitung (241) erhalten wird.

7. Kraftfahrzeug nach Anspruch 5 oder 6,
**dadurch gekennzeichnet,**
**dass** das Steuergerät (25) eingerichtet ist, um die mindestens zwei Spulenanordnungen (200) derart anzusteuern, dass sie sequentiell das jeweilige rotierende elektromagnetische Feld (80) aussenden.

8. Kraftfahrzeug nach einem der Ansprüche 5 - 7
**dadurch gekennzeichnet, dass** das Ortungssystem weiterhin umfasst:
- mindestens eine Wechselspannungs-Quelle (242), die mit den mindestens zwei Spulenanordnungen (200) und einer Versorgungsleitung (241) verbunden ist und eingerichtet ist, um zum Erzeugen des jeweiligen rotierenden elektromagnetischen Felds (80) jeweils die mindestens drei Spulen (210a, 210b, 210c) jeder Spulenanordnung (200) mit einer Wechselspannung (85) zu versorgen,
wobei die Wechselspannungen der mindestens drei Spulen (210a, 210b, 210c) in einer vorgegebenen Phasenbeziehung zueinander stehen,
wobei die Phasenbeziehung benachbarter Spulen (210a, 210b, 210c) in Abhängigkeit eines Winkels vorgegeben ist, den diese benachbarten Spulen (210a, 210b, 210c) innerhalb einer Spulenebene miteinander einschließen.

9. Kraftfahrzeug nach einem der Ansprüche 5 - 8,
**dadurch gekennzeichnet,**
**dass** eine erste der mindestens zwei Spulenanordnungen (200) im Bereich einer linksseitigen B-Säule des Kraftfahrzeugs (1) verbaut ist,
**dass** eine zweite der mindestens zwei Spulenanordnungen (200) im Bereich einer rechtsseitigen B-Säule des Kraftfahrzeugs (1) verbaut ist,
**dass** eine dritte der mindestens zwei Spulenanordnungen (200) im Bereich eines Hecks des Kraftfahrzeugs (1) verbaut ist.

10. Kraftfahrzeug nach einem der Ansprüche 5 - 9,
**dadurch gekennzeichnet,**
**dass** die mindestens zwei Spulenanordnungen (200) derart angeordnet sind, dass Rotationsebenen der mindestens zwei rotierenden elektromagnetischen Felder (30) im Wesentlichen parallel zueinander sind, und / oder
**dass** die mindestens zwei Spulenanordnungen (200) in einem Bereich von 70 cm bis 130 cm über dem Boden verbaut sind.

## Claims

1. A coil arrangement (200) for generating a rotating electromagnetic field (80), wherein the coil arrangement (200) comprises:
- at least three coils (210a, 210b, 210c), in each case having at least one associated coil winding (212a-212c),
- a ferromagnetic coil yoke (211), which establishes a magnetic coupling between the at least three coils (210a, 210b, 210c),
**characterized in that**
each of the coil windings (212a-212c) is configured as a planar conductor track (231) forming windings on a circuit board (230), the circuit board (230) has recesses (232) for the ferromagnetic coil joke (211) and the ferromagnetic coil yoke (211) is arranged above and below the circuit board (230).

2. The coil arrangement (200) according to Claim 1,
**characterized in**
**that** the at least three coils (210a, 210b, 210c) are arranged in a coil plane and that adjacent coils (210a, 210b, 210c) are arranged within the coil plane at angles (213a, 213b, 213c) of 120°.

3. The coil arrangement (200) according to Claim 1,
**characterized in**
**that** a third coil (210c) of the at least three coils (210a, 210b, 210c) encloses an angle (β) with a coil plane spanned by a first and a second coil (210a, 210b) of the at least three coils (210a, 210b, 210c).

4. A positioning system (100) for determining a position (P, P') of an identification transmitter (30) for a motor vehicle (1), the positioning system (100) comprising:
- at least two coil arrangements (200) according to any one of Claims 1-3, wherein the at least two coil arrangements (200) can be fixedly mounted at different locations of the motor vehicle and are configured, in order to be operated in each case as a transmitter for a rotating electromagnetic field (80),
- the identification transmitter (30) with a receiving coil, wherein the identification transmitter (30) is configured, in order to be operated as a receiver for the at least two rotating electromagnetic fields (30).

5. The motor vehicle comprising a positioning system (100) according to Claim 4, **characterized in that** the positioning system furthermore comprises:
- a control device (25), which is configured, in order to control the at least two coil arrangements (200) for transmitting the respective rotating electromagnetic field (80) in a predetermined sequence.

6. The motor vehicle according to Claim 5,
**characterized in**
**that** the control device (25) is coupled via a bus system (240) of the motor vehicle with at least two coil arrangements (200),
**that** each of the at least two coil arrangements (200) is coupled with a supply line (241) in the motor vehicle, and
**that** each of the at least two coil arrangements (200) is configured, in order to receive a control signal of the control device via the bus system (240) and as a function of the control signal to generate the rotating electromagnetic field (80), wherein the energy for transmitting the rotating electromagnetic field (80) is obtained via the supply line (241).

7. The motor vehicle according to Claim 5 or 6,
**characterized in**
**that** the control device (25) is configured, in order to control the at least two coil arrangements (200) in such a manner that they transmit the respective rotating electromagnetic field (80) sequentially.

8. The motor vehicle according to any one of Claims 5-7,
**characterized in that** the positioning system furthermore comprises:
- at least one alternating voltage source (242), which is connected to the at least two coil arrangements (200) and a supply line (241) and is configured, in order to supply in each case the at least three coils (210a, 210b, 210c) of each coil arrangement (200) with an alternating voltage (85) for generating the respective rotating electromagnetic field (80),
wherein the alternating voltages of the at least three coils (210a, 210b, 210c) are in a predetermined phase relationship to each other,
wherein the phase relationship of adjacent coils (210a, 210b, 210c) is predetermined as a function of an angle, which said adjacent coils (210a, 210b, 210c) enclose within a coil plane with each other.

9. The motor vehicle according to any one of Claims 5-8,
**characterized in**
**that** a first of the at least two coil arrangements (200) is installed in the area of a left-sided B pillar of the motor vehicle (1),
**that** a second of the at least two coil arrangements (200) is installed in the area of a right-sided B pillar of the motor vehicle (1),
**that** a third of the at least two coil arrangements (200) is installed in the area of a rear of the motor vehicle (1).

10. The motor vehicle according to any one of Claims 5-9,
**characterized in**
**that** the at least two coil arrangements (200) are arranged in such a manner that rotation planes of the at least two rotating electromagnetic fields (30) are substantially parallel to one another, and/or
**that** the at least two coil arrangements (200) are installed in a range of 70 cm to 130 cm above the ground.

## Revendications

1. Ensemble de bobines (200) destiné à la production d'un champ électromagnétique (80) rotatif, dans lequel l'ensemble de bobines (200) comprend :
- au moins trois bobines (210a, 210b, 210c), respectivement avec au moins un enroulement de bobine (212a-212c) correspondant,
- une culasse de bobine (211) ferromagnétique qui réalise un couplage magnétique des au moins trois bobines (210a, 210b, 210c),
**caractérisé en ce que**
chacun des enroulements de bobine (212a-212c) est constitué en tant que piste conductrice (231) plane constituant des spires sur un circuit imprimé (230),
le circuit imprimé (230) comporte des évidements (232) pour la culasse de bobine (211) ferromagnétique, et
la culasse de bobine (211) ferromagnétique est disposée au-dessus et au-dessous du circuit imprimé (230).

2. Ensemble de bobines (200) selon la revendication 1,
**caractérisé en ce que**
les au moins trois bobines (210a, 210b, 210c) sont disposées dans un plan de bobines, et
**en ce que** des bobines (210a, 210b, 210c) voisines sont disposées à l'intérieur du plan de bobines en formant des angles (213a, 213b, 213c) de 120°.

3. Ensemble de bobines (200) selon la revendication 1,
**caractérisé en ce**
**qu'**une troisième bobine (210c) des au moins trois bobines (210a, 210b, 210c) forme un angle (β) avec un plan de bobines engendré par une première et une deuxième bobine (210a, 210b) des au moins trois bobines (210a, 210b, 210c).

4. Système de localisation (100) destiné à la détermination d'une position (P, P') d'un transmetteur d'identification (30) pour un véhicule automobile (1), le système de localisation (100) comprenant :
- au moins deux ensembles de bobines (200) selon l'une des revendications 1 - 3, dans lequel les au moins deux ensembles de bobines (200) peuvent être montés de façon stationnaire à différents endroits du véhicule automobile et sont agencés pour être mis en fonctionnement respectivement en tant qu'émetteurs pour un champ électromagnétique (80) rotatif,
- le transmetteur d'identification (30) avec une bobine de réception, dans lequel le transmetteur d'identification (30) est agencé pour être mis en fonctionnement respectivement en tant que récepteur pour les au moins deux champs électromagnétiques (30) rotatifs.

5. Véhicule automobile, comprenant un système de localisation (100) selon la revendication 4,
**caractérisé en ce que** le système de localisation comprend également :
- un appareil de commande (25) qui est agencé pour piloter les au moins deux ensembles de bobines (200) pour l'émission du champ électromagnétique (80) respectif selon une séquence spécifiée au préalable.

6. Véhicule automobile selon la revendication 5,
**caractérisé en ce que**
l'appareil de commande (25) est couplé avec les au moins deux ensembles de bobines (200) par le biais d'un système de bus (240) du véhicule automobile,
**en ce que** chacun des au moins deux ensembles de bobines (200) est couplé avec une ligne d'alimentation (241) dans le véhicule automobile, et
**en ce que** chacun des au moins deux ensembles de bobines (200) est agencé pour recevoir un signal de commande de l'appareil de commande par le biais du système de bus (240) et pour produire le champ électromagnétique (80) en fonction du signal de commande de l'appareil de commande, dans lequel l'énergie pour l'émission du champ électromagnétique (80) rotatif est obtenue par le biais de la ligne d'alimentation (241).

7. Véhicule automobile selon la revendication 5 ou 6,
**caractérisé en ce que**
l'appareil de commande (25) est agencé pour piloter les au moins deux ensembles de bobines (200) de telle sorte qu'ils émettent séquentiellement le champ électromagnétique (80) rotatif respectif.

8. Véhicule automobile selon l'une des revendications 5 à 7,
**caractérisé en ce que** le système de localisation comprend également
- au moins une source de tension alternative (242) qui est raccordée aux au moins deux ensembles de bobines (200) et à une ligne d'alimentation (241) et qui est agencée pour alimenter respectivement les au moins trois bobines (210a, 210b, 210c) de chaque ensemble de bobines (200) avec une tension alternative (85) pour la production du champ électromagnétique (80) rotatif respectif,
dans lequel les tensions alternatives des au moins trois bobines (210a, 210b, 210c) entretiennent entre elles une relation de phases spécifiée au préalable,
dans lequel la relation de phases de bobines (210a, 210b, 210c) voisines est spécifiée au préalable en fonction d'un angle que forment entre elles ces bobines (210a, 210b, 210c) voisines à l'intérieur d'un plan de bobines.

9. Véhicule automobile selon l'une des revendications 5 à 8,
**caractérisé en ce**
**qu'**un premier des au moins deux ensembles de bobines (200) est installé dans la zone d'un montant B côté gauche du véhicule automobile (1),
en ce qu'un deuxième des au moins deux ensembles de bobines (200) est installé dans la zone d'un montant B côté droit du véhicule automobile (1),
en ce qu'un troisième des au moins deux ensembles de bobines (200) est installé dans la zone d'une partie arrière du véhicule automobile (1).

10. Véhicule automobile selon l'une des revendications 5 à 9,
**caractérisé en ce que**
les au moins deux ensembles de bobines (200) sont disposés de telle sorte que des plans de rotation des au moins deux champs électromagnétiques (30) rotatifs sont essentiellement parallèles entre eux, et / ou
**en ce que** les au moins deux ensembles de bobines (200) sont installés dans une zone de 70 cm à 130 cm au-dessus du sol.
